# EUROPEAN PATENT SPECIFICATION

(11) **EP 1 668 967 B1**
(45) Date of publication and mention of the grant of the patent: **04.11.2009**
(21) Application number: 04789106.4
(22) Date of filing: 27.09.2004
(51) Int. Cl.: H05K 3/38

(54) **IMPROVED METHOD FOR MICRO-ROUGHENING TREATMENT OF COPPER AND MIXED-METAL CIRCUITRY**
VERBESSERTES VERFAHREN ZUR MIKROAUFRAUHUNGSBEHANDLUNG VON KUPFER- UND MISCHMETALLSCHALTKREISEN
PROCEDE AMELIORE POUR TRAITEMENT DE MICRO-RUGOSIFICATION DE CIRCUITS DE CUIVRE ET DE METAL MIXTE

(30) Priority: 30.09.2003 US 675019
(43) Date of publication of application: 14.06.2006
(73) Proprietor: ATOTECH Deutschland GmbH, 10553 Berlin (DE)
(72) Inventor: FUERHAUPTER, Harry, Norristown, PA 19403 (US); BARON, David, Thomas, South Cerney Gloucestershire GL75TG (GB); JOHAL, Kuldip, Singh, Rock Hill, SC 29732 (US); BROOKS, Patrick, Paul, D-10589 Berlin (DE)
(74) Representative: Albrecht, Thomas
(86) International application number: PCT/US2004/031697
(87) International publication number: WO 2005/034596

(56) References cited:
- EP-A1- 0 757 118
- US-A- 5 501 350
- US-A- 5 800 859
- US-A- 6 036 758
- US-A1- 2003 029 730
- US-B1- 6 562 149

## Description

### TECHNICAL FIELD

The present invention relates to micro-roughening of metal layers for use in, e.g., circuit boards, and more particularly, to methods for micro-roughening metal layers and mixed-metal layers while avoiding or reducing problems known in the prior art.

### BACKGROUND OF THE INVENTION

In the manufacture of multi-layer circuit boards, it is necessary to use a dielectric material to separate different layers of circuitry. Electrical connections between layers are formed by creating holes in the dielectric material and depositing a conductive material within the hole, which also makes contact with two or more of the circuit layers. A variety of materials exhibit dielectric properties and can be used as a dielectric layer. A few examples include epoxy resin, phenolic resin, polyimide, bismaleimide triazine, and polytetrafluoroethylene. The metal circuitry usually consists of copper that has been patterned by a plating or etching process. In order to prevent delamination between the dielectric material and the patterned copper circuitry, due to factors such as thermal and mechanical stress subsequently applied to the circuit board, it is often necessary to treat the copper circuitry with a chemical or mechanical process that will increase its adhesion to the dielectric material.

A common method of improving the adhesion of a dielectric material to a copper surface is to roughen the copper surface, thereby increasing the surface area of the dielectric/copper interface. Roughening can be performed mechanically, such as by rubbing or spraying the copper with a slurry of pumice and water. Roughening can also be performed chemically, such as by growing copper oxide crystals on the copper surface or by micro-etching the copper surface with oxidizing solutions.

A typical solution used for growing oxide crystals on the copper surface contains sodium hydroxide and sodium chlorite. US Patent 4,844,981 by Landau describes such a process in detail. This black oxide surface may be subsequently modified with a reduction solution containing dimethylamineborane. Due to the high temperatures required for this process, the hazardous nature of the chemicals used, and the fragile quality of the oxide crystals deposited on the copper surface, alternative roughening methods have replaced the black oxide process in many circuit board manufacturing facilities.

These alternative processes are based on micro-etching the copper or metal surface. Typical micro-etching solutions may consist of persulfate salts, or mixtures of sulfuric acid and hydrogen peroxide, or mixtures of a cupric salt and a weak organic acid. These solutions may be further modified by adding complexing agents (such as ethanolamine), organic compounds (such as benzotriazole), sources of chloride (such as a chlorinated quaternary ammonium compound), and surfactants (such as polyethylene glycol). The advantage of these processes is that they usually operate at relatively low temperatures (30°C-40°C) and create a micro-roughened copper surface which is less susceptible to damage than black oxide crystals. Examples of such processes are described in patents US 6,036,758, US 6,294,220, and US 5,807,493.

In most cases, copper, or a copper-based alloy, is used as the conductive material for creating the patterned circuitry. However, there are certain instances when circuits are created from material consisting of mixed metals, such as a layered combination of copper-Invar-copper (Invar is an alloy of 64%Fe-36%Ni). This sandwiched combination of metals exhibits a relatively low amount of thermal expansion compared to a single layer of copper, so dimensional stability can be improved in a circuit board by incorporating one or more layers of copper-Invar-copper (CIC) into the design. Rather than use the CIC layer purely for dimensional stability, it is possible to create circuit patterns with the CIC and include it as part of the electrical circuit. In any case, like other copper layers, the CIC should be treated in order to improve its adhesion to the dielectric material.

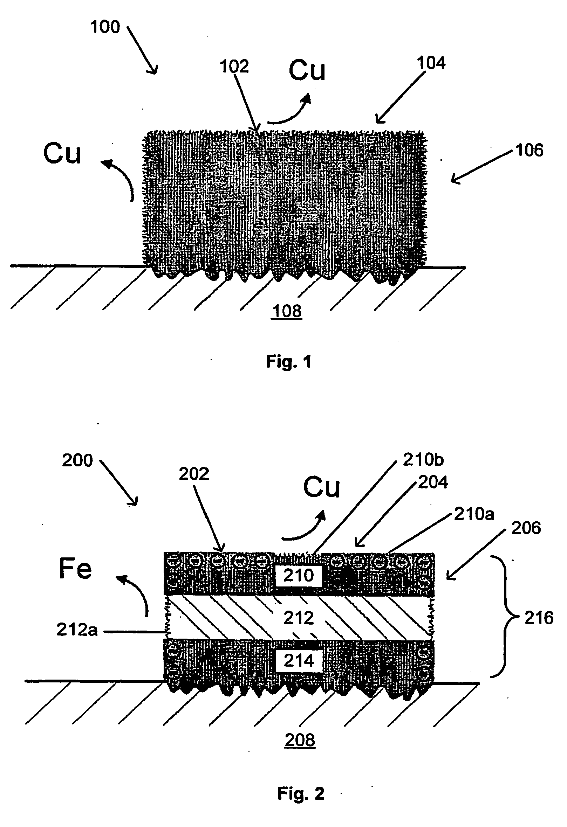

In a conventional surface etching, or micro-roughening, of a copper circuit pattern prior to appl ication of the dielectric material, all exposed surfaces of the copper circuit pattern are etched to substantially the same degree. The micro-roughening is carried out after the circuit pattern has been formed by, e.g., etching. A typical conventional micro-roughening reaction is schematically shown in Fig. 1. Fig. 1 is a schematic cross-sectional view of the micro-roughening of a nascent printed circuit 100 showing the removal of Cu from the exposed surfaces of a previously etched and formed element of a printed circuit. The nascent printed circuit 100 includes a copper circuit pattern element 102, having a top surface 104 and a side surface 106. The element 102 has been formed by a process of forming, e.g., by etching, a circuit pattern in a metal layer, and forms an element of a larger circuit pattern. The circuit element 102 in this example is attached to a dielectric substrate 108.

As shown in Fig. 1, as a result of the conventional micro-roughening, a quantity of copper is removed relatively uniformly from both the top surface 104 and the side surfaces 106 of the circuit pattern element 102, and the entire exposed surface of the circuit pattern element 102 is roughened. As noted below, the quantity of metal removed from the already-formed circuit pattern elements 102 may have undesirable effects upon the function of the circuit pattern due to the total quantity of metal removed.

When mixed-metal circuit elements, such as elements made of CIC are micro-roughened, the uniform etching obtained with copper and shown in Fig. may not be obtained. With certain copper micro-etching processes, such as sulfuric acid/hydrogen peroxide solutions containing organic additives, mixed-metal layers create an unbalanced etching effect where the interface of two different metals comes into contact with the treatment solution. When dissimilar metals which are in contact with each other are exposed to a corrosive environment, the difference in electrochemical potential of the two metals produces a flow of electrons between them. As a result of this galvanic couple, the chemical attack (e.g., micro-roughening) of the less corrosion-resistant metal will be increased, and the chemical attack of the more corrosion-resistant material will be decreased or even prevented. In the case of copper-Invar-copper, the Invar is less corrosion-resistant than the copper, and this prevents the copper from being properly micro-roughened in the areas of the circuit elements adjacent to the mixed-metal interface. In most cases, this decreased or prevented effect on the desired micro-roughening occurs on substantial portions of the top of the copper circuitry as well as on the edges.

A conventional micro-roughening reaction, including the non-roughening, with a mixed-metal layer is schematically shown in Fig. 2. Fig. 2 is a schematic cross-sectional view depicting the above-described effects when micro-roughening a nascent printed circuit 200 which includes a mixed-metal circuit pattern element 202. The circuit pattern element 202 includes a top surface 204 and side surfaces 206, and is composed of an outer layer 210 of a metal such as copper and a second, inner layer 212 of another metal, such as iron or Invar, and an underlying layer 214 of a metal which may be the same as or different from the metal of the outer layer 210. In the example shown in Fig. 2, the outer layer 210 and the underlying layer 214 are both composed of copper or a copper alloy. The three metal layers form a composite, or mixed-metal layer 216. The element 202 has been formed by a process of forming, e.g., by etching, a circuit pattern in a mixed-metal layer, and forms an element of a larger circuit pattern. The circuit element 202 in this example is attached to a dielectric substrate 208.

As shown schematically in Fig. 2, during the conventional micro-roughening of a previously formed circuit element 202, copper is removed non-uniformly from the top surface 204, and copper is substantially not removed at all from the copper portions of the side surfaces 206, due to the galvanic edge effect of the two different metals. After the micro-roughening treatment, as a result of the galvanic edge effect of the mixed-metals, significant non-micro-roughened portions 210a of the outer layer 210 remain, and only a smal I micro-roughened portion 210b, if any, of the top surface 204 of the outer layer 210 is roughened. As shown , only the portion of the top surface 204 which is sufficiently distant from the exposed portion of the inner layer 212 is effectively micro-roughened. If the circuit element is sufficiently narrow, there may be no micro-roughening of the top surface 204.

As shown schematically in Fig. 2, metal at the edges of the inner layer, e.g., iron or with INVAR, iron and nickel, is removed from the inner layer 212, to form a micro-roughened edge 212a, due to the higher activity of iron as compared to copper. Thus, on the side surfaces 206, only the exposed portion 212a of the second metal is effectively micro-roughened, resulting in a non-uniform removal of metal from both the side surfaces 206 and the top surface 204 of the circuit element 202. Thus, when a mixed-metal layer 216 is etched to form printed circuit elements 202 and is subsequently micro-roughened, the micro-roughening is quite uneven, as shown in Fig. 2.

As a result, the adhesion of dielectric material to the copper pattern may be poor since the adhesion has not been improved due to the unsuccessful micro-roughening. This non-micro-roughening effect is so dramatic that it can be seen by visual inspection without the aid of a microscope. Treatment with a solution of sulfuric acid/hydrogen peroxide modified with organic additives usually creates a brown color on the surface of the copper. However, in the case of mixed metals, the surface of the etched patterns remain the color of untreated copper. In the middle of the circuit elements 202 (e.g., area 210b in Fig. 2), where the copper is relatively distant from the mixed metal interface, the copper micro-roughening treatment may appear normal. However, there is a significant area of untreated copper toward the edges of the elements 202 (e.g., the areas 210a in Fig. 2). Any such untreated copper surface is undesirable and may require the product to be scrapped due to poor adhesion of the metal to later-applied laminate materials.

Some manufacturers of metal foils such as copper-Invar-copper and copper foil pre-treat the metal foil in order to provide a coating on the surface which has improved adhesion to dielectric material. For example, dendritic copper may be applied to the metal foil. This process greatly increases surface roughness, but may result in other problems, such as resist lock-in. This is a situation where the etch resist is trapped in the deep crevices of the foil treatment and cannot be easily developed or stripped. The locked-in resist can cause defects such as electrical shorts. In general, the type of surface treatment provided on mixed-metal foil is adequate for dielectric adhesion, but problematic for etch resist patterning and removal.

Another limitation of the state of the art is the large number of process steps used to pattern a metal layer. A typical circuit patterning process comprises step (1) cleaning; step (2) micro-etching; step (3) etch resist application; step (4) etch resist patterning; step (5) pattern etching; step (6) etch resist removal; step (7) cleaning; step (8) pre-conditioning; step (9) micro-roughening; step (10) dielectric application. In this sequence, there are two etching steps which reduce the overall metal layer thickness (steps 2 and 9) and two etching steps which impact the metal pattern width (steps 5 and 9).

Another problem in the conventional process of etching followed by micro-roughening results from the total quantity of metal removed from the circuit pattern during the micro-roughening of pre-formed or prepatterned circuit elements. As noted above, in micro-roughening a single-metal circuit pattern, the metal is removed relatively uniformly from all exposed surfaces, thus reducing the size of the circuit elements so treated. Since the electrical resistance of a patterned circuit is dependent on the width and thickness of the conductor, it would be desirable to reduce the number of metal removal steps, as well as the total quantity of metal removed, in the circuit patterning process, especially after the metal pattern has been formed (step 5). This becomes more critical the more narrow the circuit elements are made. For example, consider a copper pattern with a width of 25 microns and a thickness of 17 microns. If the micro-roughening (step 9) removes 1.5 microns of copper from the exposed surfaces, the pattern dimensions after micro-roughening would be 22 microns wide and 15.5 microns thick. This equates to a 20 percent reduction in cross-sectional area. The electrical resistance of a copper pattern is a function of its cross-sectional area, as defined by the equation R =pVL/A, where pV is the volume resistivity of the copper, L is the length of the pattern, and A is the cross-sectional area. Therefore, a 20 percent decrease in cross-sectional area results in a 25 percent increase in the resistance. This example illustrates the need to reduce the amount of metal removal after the pattern formation step.

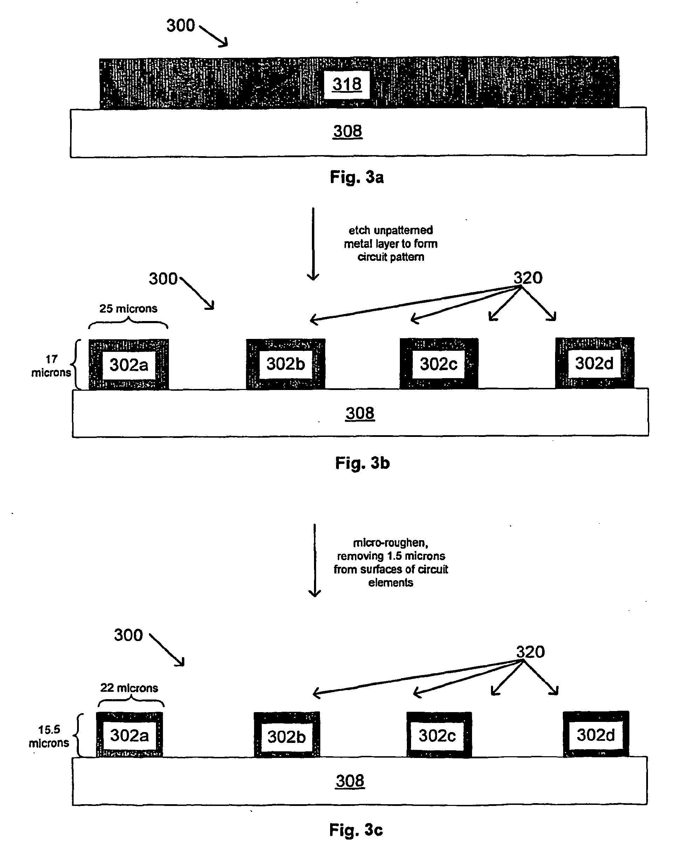

Figs. 3a-3c are schematic cross-sectional views of a conventional process of pattern etching followed by micro-roughening, demonstrating the loss of metal from the circuit pattern elements resulting from conventional micro-roughening following formation of a circuit pattern. As shown in Fig. 3a, a nascent circu it board 300 is provided, including an unpatterned metal layer 318 on a dielectric substrate 308. The unpatterned metal layer 318 is then patterned, by applying a resist, developing, and etching, to form a circu it pattern 320, as shown in Fig. 3b. As shown, the circuit pattern 320 includes individual circuit elements 302a-302d.

The effect of the loss of metal due to the post-circuit element formation micro-roughening treatment mentioned above may be illustrated as follows with reference to Figs. 3a-3c. As shown in Fig. 3b, a single circuit element 302a may have, for example, an initial width of 25 microns and an initial thickness of 17 microns. In the conventional process, a micro-roughening treatment is applied to the previously formed circuit pattern 320, in order to enhance adhesion between the pattern and a subsequently applied dielectric material. As known in the art, a typical exemplary micro-roughening treatment may remove about 1.5 microns from the all exposed surfaces of the metal of the circuit pattern 320. As illustrated in Fig. 3c, following the micro-roughening of this example, which removes 1.5 microns of metal from all exposed surfaces of each of the circuit elements 302a-302d, the circuit elements 302a-302d are noticeably smaller. It is noted that the surface of the circuit elements 302a-302d in Fig. 3c have been micro-roughened, as indicated in the transition from Fig. 3b to Fig. 3c, although the imparted roughness is not specifically shown in Fig. 3c. Fig. 3c is intended to illustrate the loss of metal from the circuit elements 302a-302d.

When 1.5 microns are removed from all the exposed surfaces in the micro-roughening, the exemplary circuit element 302a has been reduced to about 22 microns wide by about 15.5 microns thick as indicated for this element 302a in Fig. 3c. As discussed above, this equates to a 20 percent reduction in cross-sectional area. This loss in cross-sectional area reduces the current-carrying capacity of the circuit element, thus increasing the resistance thereof. As circuit elements are further reduced in size, such effects become more pronounced. This can create significant problems for the ever-smaller circuitry, since the conventional solution to this problem requires forming larger circuit elements to compensate for the loss of metal in subsequent micro-roughening.

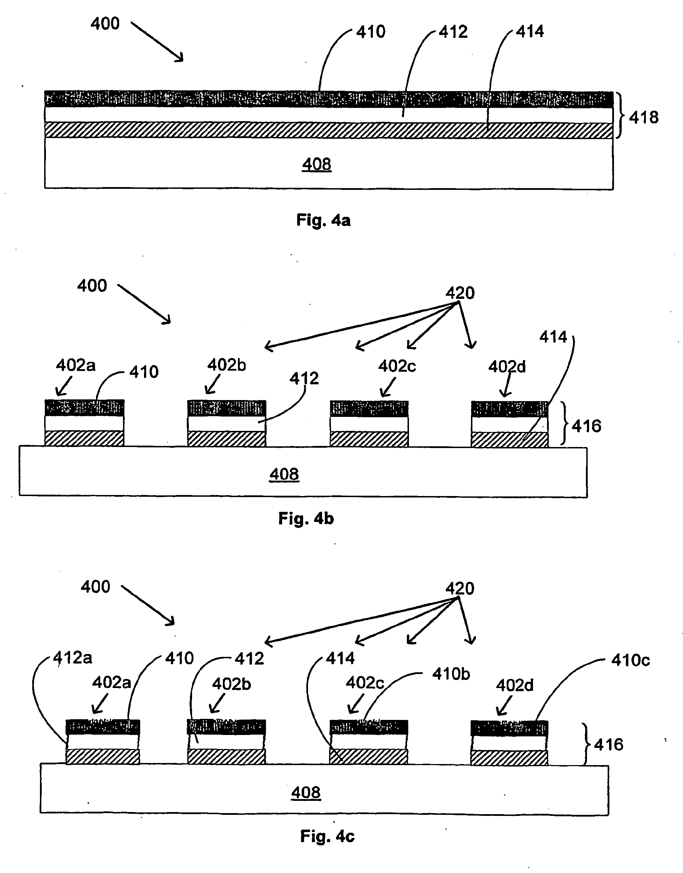

Figs. 4a-4c are schematic cross-sectional views of a conventional process of pattern etching followed by micro-roughening for mixed-metal layers, demonstrating the problem of edge effects resulting from a mixed-metal circuit pattern element. Fig. 4a depicts a nascent circuit board 400, in which an unpatterned mixed-metal layer 418 on a substrate 408 has been provided. Similar to the structure described with respect to Fig. 2, the unpatterned mixed-metal layer 418 includes an outer layer 410 of a metal such as copper or a copper alloy, an inner layer 412 of a different metal, such as Invar, and an underlying layer 414, of a metal such as copper or a copper alloy or, possibly, a different metal. These three layers together form the unpatterned mixed-metal layer 418.

Fig. 4b depicts the nascent circuit board 400 after the unpatterned mixed-metal layer 418 has been etched to form a mixed-metal circuit pattern 420 including a plurality of circuit elements 402a-402d. The circuit elements 402a-402d form part of a patterned mixed-metal layer 416, shown in Fig. 4b. The patterned mixed-metal layer 416 corresponds to the unpatterned mixed-metal layer 418, except that it has been etched to form the circuit elements 402a-402d.

As shown in Fig. 4b, the mixed-metal circuit pattern 420 includes the individual circuit pattern elements 402a-402d on a dielectric substrate 408, similar to the circuit pattern 320 shown in Figs. 3b and 3c. In this embodiment, the mixed-metal circuit pattern 420 has been formed by etching the unpatterned mixed-metal layer 418.

As shown in Fig. 4c, when the circuit pattern elements 402a-402d of the formed circuit pattern 420 are micro-roughened thereafter, the problem described above with respect to the Fig. 2 example results. I n this mixed-metal embodiment, when the circuit elements 402a-402d of the mixed-metal circuit pattern 420 are subjected to micro-roughening, the galvanic edge effect described above with respect to Fig. 2 occurs, resulting in significantly reduced micro-roughening on most surfaces of the circuit elements 402a-402d. As shown in Fig. 4c, micro-roughening occurs only in exposed portions of the inner layer 412 and in center portions 410b of the individual circuit elements 402a-402d (assuming the circuit elements are sufficiently wide that at least some portion of the top surface is free of the galvanic edge effect of the mixed-metal layer). As shown in Fig. 4c, only the exposed edges 412a of the inner layer 412 of each circuit element 402a-402d are micro-roughened, as described above, when the inner layer 412 comprises a metal which is more active than the top layer 410. Thus, as described above with respect to Fig. 2, when the edge effect occurs, significant portions of the top layer 410 are left un-roughened, thus compromising effective adhesion to subsequently applied dielectric materials.

In typical circuit patterning processes such as that outlined above for single-metal layers, It is not possible to simply skip the micro-roughening step (9) because the surface roughness created by the micro-etching step (2) is insufficient to allow reliable adhesion of the dielectric layer. In the mixed-maal layer embodiments, It Is not possible to obtain adequate roughening and as a result may not be possible to obtain adequate adhesion of the metal to later-applied laminate materials due to the edge effects described. The purpose of the micro-etching Is to Improve the adhesion of etch resist without creating a permanent bond. The etch resist must be able to be stripped easily and completely from the micro-etched surface. For this reason, solutions used for micro-etching prior to application of etch resist typically do not create the same magnitude of roughness as micro-roughening solutions which are used for improving the adhesion of a permanent dielectric layer. Thus, since the micro-etch roughness Is usually not sufficient to enhance adhesion to subsequently applied dielectric laminate materials, the micro-roughening needs to be included. However, doing so may result in loss of a substantial amount of the circuit pattern cross-sectional area. If the circuit pattern elements are made larger initially to compensate for this later loss, the sought reduction In overall circuit pattern size cannot be obtained, thus inhibiting needed size reduction.

A solution to the foregoing limitations and problems of the conventional processes is needed.

US Patent 5,501,350 by Yoshida et al. describes a process to improve adhesion of dielectric materials (a photosensitive dry film) to a metal (copper foil) layer, namely a process for producing a printed wiring board, comprising the steps of forming a photosensitive resist layer on a copper layer provided on an insulating substrate, patterning the photosensitive resist layer, and etching the copper layer made bare from the photosensitive resist layer to form a copper wiring layer, wherein the surface of said copper layer is subjected to pretreatment comprising the steps of black-oxide treating the surface by the use of an alkaline oxidizing solution and subsequently finely surface-roughening the black-oxide treated surface by the use of an acidic treating solution comprised of phosphoric acid or an organic acid, followed by drying in the presence of oxygen, and thereafter said photosensitive resist layer is formed thereon. The micro roughening is carried out prior to the etching. The surface thus obtained is a finely irregular surface with a peak-to-valley distance of 0.2 to 0.05 µm or less.

### SUMMARY OF THE INVENTION

Considering the limitations of the existing micro-roughening processes used in creating multilayer circuit boards, the present invention provides a process which allows the treatment of mixed-metal circuitry without the negative effect of untreated edges resulting from micro-etching of mixed-metal layers. The present invention also provides a process having a reduced number of metal roughening steps in the conversion of a mixed-metal layer or a copper layer into a patterned circuit including a surface treatment that promotes adhesion to a dielectric material. In particular, the present Invention avoids any metal etching or micro-roughening after the circuits pattern has been formed so that the cross-sectional area of the circuit pattern elements are not significantly reduced subsequent to formation of the circuit patterns.

The present invention relates, In one embodiment, to a process to improve the adhesion of mixed-metal layers to dielectric material by micro-roughening while avoiding or reducing substantially the negative galvanic coupling edge effect which results in untreated pattern surfaces, and which avoids the problem of excessive loss of metal in a single-metal circuit pattern which may occur when the pattern is formed prior to the micro-roughening. This process also obviates any need for metal etching or micro-roughening steps after a circuit pattern has been formed in a mixed-metal layer or a copper layer, thus preventing significant changes in the cross-sectional area of a circuit pattern. The present invention addresses and substantially reduces the problems associated with the prior art, namely (1) the problem of copper surface of a mixed-metal circuit layer treated with certain micro-roughening solutions having non-treated areas that are visible to the naked eye and have poor adhesion to dielectric material; and (2) the problem of the micro-roughening step performed after pattern formation decreasing the cross-sectional area of the pattern and thus increasing the electrical resistance of the circuit pattern elements.

Thus, in one embodiment (which is defined in claim 1 and may be referred to herein as the first embodiment), the invention relates to a process to improve adhesion of dielectric materials to a metal layer, including providing an unplatterned metal layer having a first major surface; micro-roughening the first major surface to form a micro-roughened surface; and etching the metal layer to form a circuit pattern in the metal layer, wherein the micro-roughening is carried out prior to the etching and the micro-roughened surface has a surface roughness rₐ as measured by profilometer of peak-to-valley height of features on the micro-roughened surface from 0.3 to 0.6 microns, and in the micro-roughening, surface area of the micro-roughened surface is increased by a factor of greater than 40% relative to the surface prior to the micro-roughening.

In another embodiment (which is defined in claim 2 and may be referred to herein as the second embodiment), the invention relates to such a process to improve adhesion of dielectric materials to a metal layer, comprising:
a. providing an unpatterned metal layer having a first major surface;
b. micro-roughening the unpatterned metal layer with a micro-roughening solution to form a micro-roughened surface on the first major surface;
c. applying an etch resist to the micro-roughened surface:
d. patterning the etch resist to reveal areas of metal to be removed;
e. etching the metal layer which is not protected by the etch resist to form a circuit pattern; and
f. removing the etch resist.

In yet another embodiment (which is defined in claim 3 and may be referred to herein as the third embodiment), the invention relates to such a process to improve adhesion or dielectric materials to a metal layer, comprising:
a. providing an unpatterned metal layer having a first major surface;
b. micro-roughening the unpatterned metal layer with a micro-roughening solution to form a micro-roughened surface on the first major surface;
c. applying an etch resist to the micro-roughened surface:
d. patterning the etch resist to reveal areas of metal to be removed;
e. etching the metal layer which is not protected by the etch resist to form a circuit pattern;
f. removing the etch resist;
g. optionally applying a secondary metal coating to the micro-roughened surface; and
h. applying a dielectric to the micro-roughened surface.

In one embodiment, the process further comprises a step of pre-cleaning the first major surface. An additional preconditioning step may be added between the pre-cleaning step and step (b) to enhance the uniformity of the treatment in step (b). Additional treatment steps may be added between steps (g) and (h) to further enhance the adhesion properties of the metal pattern to the dielectric material without substantially modifying the underlying metal structure. An additional step may be added between steps (b) and (c) or between steps (f) and (g) to chemically adjust the color of the micro-roughened surface in order to aid optical inspection.

The process In accordance with the present invention Is simpler and shorter (i.e., Includes fewer steps) than a typical circuit patterning sequence. Treating the copper surface Is carried out by bringing the copper surface into contact with the appropriate solutions. Optical inspection may be performed manually or automatically. Copper-Invar-copper layers treated in accordance with the invention have a uniformly micro-roughened upper surface with none of the original copper color visible to the naked eye. In mixed-metal embodiments, in the present Invention, the area of non-roughening Is restricted to a narrow band along the outer edges of the unpatterned layer or panel. This area is normally trimmed away and not used in the final product. Adhesion of the micro-roughened metal surfaces to subsequently applied dielectric material is not problematic (no peeling or blistering). In embodiments in which the optional metal coating is applied by step (g), the adhesion is further enhanced, and even the side walls of the circuitry (which in one embodiment are not micro-roughened) have improved adhesion to the dielectric layer. As a result of the process of the present invention, the cross-sectional area of a patterned circuit made with mixed-metal or copper is not significantly reduced after step (e). Overall, there are fewer process steps required to create a patterned circuit layer with improved adhesion to dielectric material. The described process is therefore advantageous for manufacturing multilayer printed circuit boards.

### BRIEF DESCRIPTION OF THE DRAWINGS

Fig. 1 is a schematic cross-sectional view of micro-roughening of a standard copper circuit pattern element.
Fig. 2 is a schematic cross-sectional view of micro-roughing of a mixed-metal circuit pattern element, in which an outer layer is copper and a second, inner layer includes another, more active metal such as iron or Invar.
Figs. 3a-3c are schematic cross-sectional views of a conventional process of pattern etching followed by micro-roughening, demonstrating the loss of metal from the circuit pattern elements.
Figs. 4a-4c are schematic cross-sectional views of a conventional process of pattern etching in a mixed-metal layer followed by micro-roughening, demonstrating the galvanic edge effects resulting from the differences between the metals of the mixed-metal layers in the circuit elements.
Fig. 5 is a photomicrograph of a micro-roughened surface, in accordance with an embodiment of the present invention.
Fig. 6 is a photomicrograph of a conventional micro-etched surface.
Figs. 7a-7c are schematic cross-sectional views of a process according to an embodiment of the present invention, including micro-roughening the surface of a mixed-metal layer, followed by etching of the layer to form circuit pattern elements.
Fig. 8a-8c are schematic cross-sectional views of a process according to an embodiment of the present invention, including micro-roughening the surface of a single metal layer, followed by etching of the layer to form circuit pattern elements.

It should be appreciated that for simplicity and clarity of illustration, elements shown in the Figures have not necessarily been drawn to scale. For example, in some Figures, the vertical dimensions of some of the elements may be exaggerated relative to horizontal dimensions for clarity. Further, where considered appropriate, reference numerals have been repeated among, or corresponding numbers have been used in, the Figures to indicate corresponding elements.

### DETAILED DESCRIPTION

It should be appreciated that the process steps and structures described below do not form a complete process flow for manufacturing and using a printed circuit board or other end-product made by a process including the present invention. The present invention can be practiced in conjunction with fabrication techniques currently used in the art, and only so much of the commonly practiced process steps are included as are necessary for an understanding of the present invention.

As used herein, the term "micro-roughening" may also be referred to as an intergranular etching process. The details of suitable micro-roughening methods and compositions are described below. In the micro-roughening process, the surface of a metal such as copper or a mixed-metal is chemically treated to increase both its surface area and Its roughness. In the micro-roughening, the surface is treated to increase its surface area by a factor of greater than 40%. In another embodiment, in the micro-roughening, the surface Is treated to increase Its surface area by a factor of from about 40% to about 200%, In one embodiment, In the micro-roughening, the surface is treated to Increase its surface area by a factor of from about 50% to about 100% and In another embodiment, in the micro-roughening, the surface is treated to increase its surface area by a factor of from about 60% to about 120%. Surface area may be measured by any appropriate method. One suitable method for measuring surface area is by use of a 3-D atomic force microscope (AFM) topographic analysis of the surface. Suitable AFM apparatus Is commercially available, for example, from Veeco Instruments Inc., Woodbury, NY.

In the micro-roughening, the surface is treated to increase its roughness to a roughness (rₐ) as measured by profilometer of peak-to-valley height of features on the micro-roughened surface in the range from about 0.3 micron to about 0.6 micron, and in another embodiment, in the micro-roughening, the surface is treated to increase its roughness (rₐ) as measured by profilometer in the range from about 0.3 micron to about 0.5 micron, and in one embodiment, about 0.4 micron. Here, as elsewhere in the specification and claims, the numerical limits of the disclosed ranges and ratios may be combined.

Micro-roughening may be carried out by any of the methods described in detail hereinbelow, or by other suitable methods which may be known In the art.

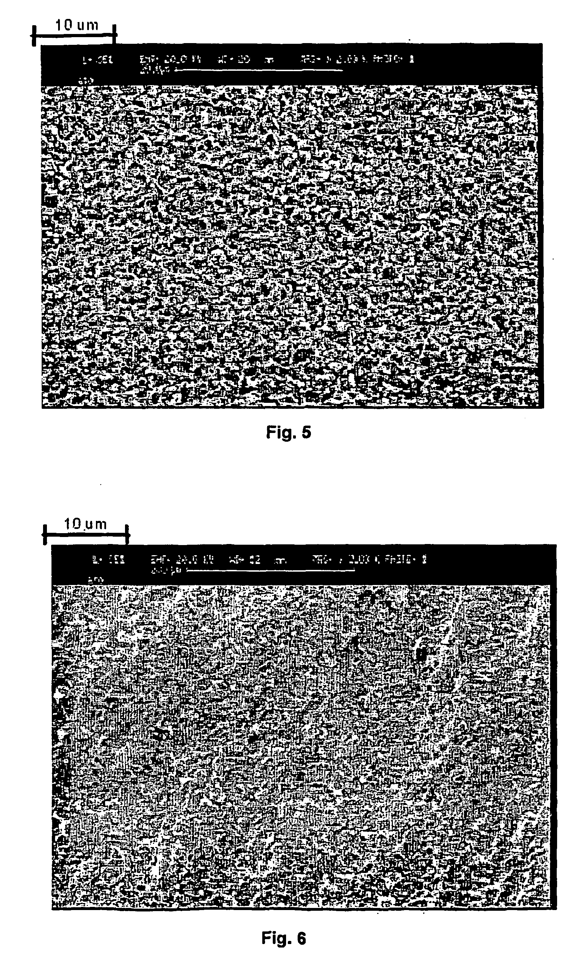

Figs. 5 and 6 are photomicrographs of metal surfaces obtained from originally identical metal surfaces, which have been subjected, respectively, to micro-roughening and to micro-etching. Thus, Fig. 5 is a photomicrograph of a metal surface which has been treated to increase its surface area and roughness by micro-roughening in accordance with the present invention. In the metal layer shown in Fig. 5, the surface area was increased by 107%, and the roughness (rₐ) as measured by profilometer is 0.412 micron, as a result of the micro-roughening. As shown in Fig. 5, the surface not only has increased roughness (rₐ) as measured by profilometer, but Includes a significantly increased surface area.

As used herein, the term "micro-etching" refers to surface preparation in which the surface of a metal such as copper is chemically treated to form a matte surface having a roughness (rₐ) as measured by profilometer in the range from about 0.1 micron to about 0.3 micron, but which generally does not include a greatly increased surface area. Thus, micro-etching, as used herein, increases the roughness of the surface as measured by profilometer, and Increases the surface area to some degree, but less than the surface area increase obtained by micro-roughening. The increase in surface area obtained by micro-etching ranges from about 5% to less than 40% at the greatest Thus, while conventional micro-etching processes increase the roughness (rₐ) of the surface as measured by profilometer, such processes do not obtain an increase In surface area of the same magnitude as that which can be obtained by micro-roughening. As known in the art, the roughness (rₐ) as measured by profilometer is a measure of the peak-to-valley height of surface features on the metal surface, and this measurement does not reflect changes In surface area of the metal surface.

Fig. 6 is a photomicrograph of a metal surface (obtained from the same original metal surface as that shown in Fig. 5), which has been treated by micro-etching. In the metal layer shown in Fig. 6, the surface area was increased by 21%, and the roughness (rₐ) as measured by profilometer is 0.252 micron, as a result of the micro-etching. As shown In Fig. 6, the surface has an increased degree of roughness (rₐ) as measured by a profilometer, but does not exhibit the high surface area of the micro-roughened metal surface shown In Fig. 5, as described above. Thus, while the micro-etched metal surface has a roughness (rₐ) as measured by a profilometer in a range which may overlap the roughness (rₐ) as measured by a profilometer of a micro-roughened metal surface, the micro-etched metal surface has a much lower surface area. This difference Is readily apparent by comparison of the metal surfaces depicted In Figs. 5 and 6.

Micro-etching may be carried out, for example, by applying a composition including a persulfate or a monopersulfate, such a OXONE®, which contains persulfate and is available from E. I. Du Pont de Nemours and Co., Inc.

As used herein, the term "pre-treatment roughening" refers to surface preparation In which the surface of a metal such as copper is treated to form, e.g, dendritic structures on its surface, having a roughness (rₐ) as measured by profilometer Is In the range' from about 1 micron to about 3 microns. Application of a dendritic surface to copper foil is described, for example, in U.S. Patent No. 6,042,711, assigned to Gould Electronics, Inc. Such pre-treatment roughening processes are metal-deposition processes as opposed to micro-etching and micro-roughening processes, which are metal-removal processes.

In the first embodiment, which is defined by claim 1, the invention relates to a process to improve adhesion of dielectric materials to a metal layer, including providing an unpatterned metal layer having a first major surface; micro-roughening the first major surface to form a micro-roughened surface; and etching the metal layer to form a circuit pattern in the metal layer, wherein the micro-roughening is carried out prior to the etching and the micro-roughened surface has a surface roughness rₐ as measured by profilometer of peak-to-valley height of features on the micro-roughened surface from 0.3 to 0.6 microns, and in the micro-roughening, surface area of the micro-roughened surface is increased by a factor of greater than 40% relative to the surface prior to the micro-roughening. In one embodiment, prior to the micro-roughening, no surface treatment to increase the roughness of the metal layer is carried out. In one embodiment, no further surface treatment to increase the roughness of the metal is carried out subsequent to the etching to from the circuit pattern.

In the second embodiment, the invention relates to such a process to improve adhesion of dielectric materials to a metal layer, comprising:
a. providing an unpatterned metal layer having a first major surface;
b. micro-roughening the unpatterned metal layer with a solution to form a micro-roughened surface on the first major surface;
c. applying an etch resist to the micro-roughened surface;
d. patterning the etch resist to reveal areas of metal to be removed;
e. etching the metal layer which is not protected by the etch resist to form a circuit pattern;
f. removing the etch resist.
As in the first embodiment, in one embodiment of this second embodiment, no further surface treatment to increase the roughness of the metal is carried out subsequent to the etching (e). In one embodiment, prior to the micro-roughening, no surface treatment to increase the roughness of the metal layer is carried out.

The micro-roughening and etching processes are described in detail in the following. The process description is provided for both copper-Invar-copper ("CIC") as the conductive circuit material, and thereafter, for copper as the conductive circuit material. The present invention is applicable to copper and alloys of copper with other metals, other metals and alloys including, for example, aluminum, molybdenum, iron, nickel, tin, zinc, beryllium, silicon, cobalt, phosphorus, lead, manganese, magnesium and chromium, and to other mixed-metal sandwiches, in addition to CIC, in which an inner layer of another metal, such as, for example, molybdenum or aluminum, is sandwiched between two outer layers of copper or copper alloy. Although the currently most widely used mixed-metal sandwich is CIC, this invention is broadly applicable to any similar mixed-metal sandwich, in which an inner layer of one metal or alloy is sandwiched between two outer layers of other metal(s) or alloy(s), and at least one of the metal or alloy of the inner layer interferes electrolytically with surface etching of the outer metal layer(s). Unless otherwise specified, the disclosure fully applies to copper, copper alloys and to mixed-metal sandwiches. The effects described herein are particularly applicable to mixed-metal sandwiches in which the inner layer is a metal which is more active galvanically than the outer layers. However, as will be understood, a similar effect may occur when the inner layer is the less active metal. The processes described herein are fully applicable to single layers, such as copper or copper alloys, which are not susceptible to the same problems as are mixed-metal layers. In such single-layer cases, the benefits of the present invention include the avoidance of loss of cross-sectional area of formed circuit pattern elements, as described above with respect to Figs. 3a-3c. Although specific examples of products are given, they are not intended to limit the application of the invention to the use of those products.

### MIXED-METAL LAYER

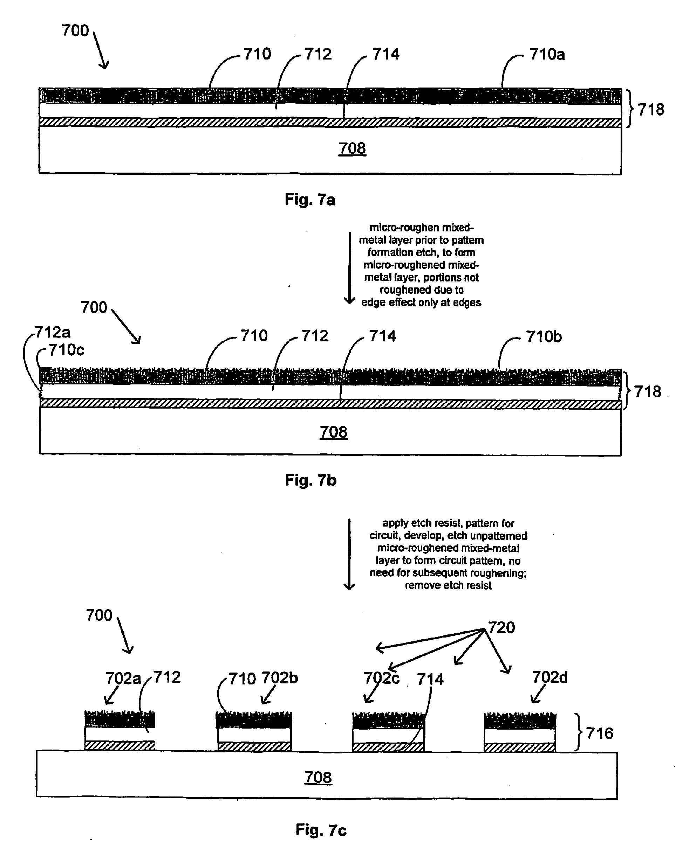

A process in accordance with the second embodiment of the present invention is described with reference to Figs. 7a-7c. Figs. 7a-7c are schematic cross-sectional views of a process according to an embodiment of the present invention, including micro-roughening the surface of a mixed-metal layer, followed by etching of the layer to form circuit pattern elements.

As a first step (a) in the second embodiment of the process of the present invention, an unpatterned metal or mixed-metal layer, such as an 18-20 inch (1 inch = 2,54 cm) wide sheet of copper or CIC, is provided.

Fig. 7a is a schematic cross-sectional view of a nascent circuit 700, such as a printed circuit board, including an unpatterned mixed-metal layer 718 adhered or attached to a dielectric material layer 708. The mixed-metal layer 718 includes a top layer 710 of a first metal or alloy and an inner layer 712 of a second metal or alloy, and an underlying layer 714, which may be the same metal or alloy as the top layer 710, although in one embodiment, the underlying layer 714 may comprise a different metal or alloy. The three layers 710, 712 and 714 form the mixed-metal layer 718. The top layer 710 has a first major surface 710a, which in this embodiment is the only exposed surface of the mixed-metal layer 716, except for the side or edge surfaces of the mixed-metal layer 718.

In one embodiment, the unpatterned mixed-metal layer 718 is provided in a continuous roll, and in another embodiment, the metal layer is provided in a square or rectangular sheet. In one embodiment, the unpatterned metal layer 718 is provided already adhered to a dielectric material layer 708. In another embodiment, the unpatterned mixed-metal layer 718 is provided and is subsequently applied to the dielectric material layer 708 prior to the micro-roughening and patterning. In yet another embodiment, the unpatterned mixed-metal layer 718 is provided, the micro-roughening carried out and the circuit pattern formed, and subsequently the formed circuit pattern is applied to the dielectric material layer 708. In one embodiment, prior to the micro-roughening, no surface treatment to increase the roughness of the metal is carried out.

The CIC foils used with this invention are commercially available from, e.g., Texas Instruments, Inc. and Gould Electronics, Inc., and are supplied as a clad starting material in various inlay ratios. The inlay ratios for the CIC may range, for example, from about 12.5%/75%/12.5% to about 30%/40%/30%, including, for example 20%/60%/20%. CIC and similar mixed-metal layers may be provided in a thickness of approximately 6 mil (about 0.15 mm), for example. The CIC and similar mixed-metal layers may be rolled to reduce the thickness as appropriate, if needed.

Such metal foils may be provided in various panel sizes, such as 18" x 24", 12" x 18" or 20" by 24.5" to about 26" (1" = 2.54 cm) Each panel generally comprises a plurality of sections, each of which will eventually become, for example, a single conductive layer of a PCB.

The metal layer may comprise any of the metals disclosed above, either as a single layer or as a mixed-metal sandwich. The metal layer has a first major surface, which is the surface of the metal layer to which the treatments disclosed herein are applied, and to which the dielectric material will eventually be applied. A second major surface of the metal layer may have been attached or adhered, as by lamination, to a dielectric material, in which case only the first major face is treated as disclosed herein. In one embodiment, the metal layer is not attached or adhered to a dielectric material, in which case the second major surface of the metal layer may also be treated as disclosed herein.

As known in the art, metal surfaces may be first cleaned to ensure that any contamination on the copper surface does not interfere with the copper surface treatment. Thus, in one embodiment, the unpatterned metal layer is cleaned prior to any further treatments being applied. Any conventional cleaning solution can be used. In one embodiment, surfactants and in other embodiments, complexing agents (such as triethanolamine), or in other embodiments, both surfactants and complexing agents, are added to aqueous cleaning solutions for improved cleaning ability. In many embodiments, an aqueous alkaline cleaner is used for removing residues, such as oils, dusts, etc., created by human contact with the copper surface. In one embodiment, the cleaning operation comprises application of a 100 ml/l solution of Basiclean® UC, supplied by Atotech, in water. The solution may be sprayed onto the metal at about 20 psi (1 psi = 0.06895 bar) at about 50°C for about 1 minute, for example, followed by rinsing with, e.g., deionized water. Basiclean® UC is an alkaline cleaner including about 35 wt% sodium hydroxide.

Depending on the micro-roughening chemistry and the mode of application, it may be helpful to employ a pre-conditioning step to assist in making the micro-roughening uniform over the entire surface of the copper. By creating a uniform surface potential on the copper, the pre-conditioner assists in initiating the micro-roughening reaction at substantially the same time over the entire surface area of the metal layer. The pre-conditioner may comprise surfactants and/or components of the micro-roughening composition, such as alcohols, alkoxyalcohols, polyalkoxyalcohols, triazoles and other components which interact with the surface of the metal layer.

In one embodiment, the pre-conditioner includes a water soluble alcohol. As used herein, an alcohol is water soluble when it has water solubility of at least about 0.05 M. In one embodiment, the water soluble alcohol may include one or more of C₁-C₆ straight chain and C₃-C₈ branched chain alcohols, C₂-C₁₂ alkoxyalcohols and C₃-C₂₄ polyalkoxyalcohols. In one embodiment, for example, the alcohol may comprise isopropyl alcohol, isopropoxyethanol, or ethoxyethoxyethanol. In another embodiment, the pre-conditioner includes a non-ionic surfactant such as a polyethoxyethanol. The number of carbon atoms in the water soluble alcohol may vary over a wide range, provided that the water soluble alcohol retains water solubility, as defined.

In another embodiment, the pre-conditioning solution may further include a corrosion inhibitor. Suitable corrosion inhibitors include, for example, triazoles such as benzotriazole, tetrazole and substituted tetrazoles, thiadiazoles, thiatriazoles, imidazoles, benzimidazoles, etc. Suitable corrosion inhibitors are known in the art, and are disclosed, for example, in U.S. Patent No. 6,506,314 B1, the disclosure of which is incorporated by reference with respect to organic corrosion inhibitors.

A suitable pre-conditioning solution is commercially available from Atotech as BondFilm® Activator, available from Atotech. In one embodiment, the pre-conditioner comprises a 20 ml/l solution of BondFilm® Activator. BondFilm® Activator contains isopropoxyethanol, benzotriazole and other proprietary ingredients. The metal is immersed in this solution for 30 seconds at 35°C. No rinsing is needed or required between the pre-conditioning step and the microroughening step because, as noted, the additives in the pre-conditioner interact with the metal surface to improve the micro-roughening reaction.

Following treatment with such pre-conditioning solution, it is generally not necessary to rinse the metal surface prior to the next step. In one embodiment, when the pre-conditioning solution contains a corrosion inhibitor which is the same or similar to that used in the following micro-roughening treatment, it is not necessary to rinse the pre-conditioned metal surface. In particular, when the BondFilm® Activator is used for pre-conditioning, and the micro-roughening is carried out using BondFilm® from Atotech, not only is rinsing not necessary, it is not desirable. This is because the pre-conditioning treatment helps to prepare the metal surface for the subsequent micro-roughening treatment, and thus the treatment is desirable to be retained on the surface.

In the next step (b) of the second embodiment of the process of the present invention, shown in Fig. 7b, the first major surface 710a of the unpatterned mixed-metal layer 718 is treated with a micro-roughening solution, in a step of micro-roughening the surface 710a, to create a micro-roughened surface 710b of the unpatterned mixed-metal layer 718. A number of solutions suitable for micro-roughen ing the surface 710a in order to create the micro-roughened surface 710b are described in detail hereinbelow.

As shown in Fig. 7b, following the micro-roughening, the unpatterned mixed-metal layer 718 has a micro-roughened surface 710b. In addition, as shown in Fig. 7b, the mixed-metal layer 718 also includes an un-etched edge portion 710c. As described above, this un-etched edge portion 710c is a portion of the top layer 710 which remains un-etched as a result of the galvanic edge effect. As schematically shown in Fig. 7b, in accordance with the present invention, the un-etched edge portion 710c advantageously occurs only at the edges of the mixed-metal layer 718, leaving the entire remaining first major face of the mixed-metal layer 718 relatively evenly micro-roughened as desired. In the normal course of preparing circuits such as described herein, these edge portions 710c of the mixed-metal layer 718 would be removed subsequent to the pattern formation in any case. Since this area of the panel normally does not contain active circuitry, the lack of micro-roughening in this area does not reduce the quality or performance of the final product. This area is usually trimmed off when the individual circuits are removed from the panel. Thus, the fact that these edge portions 710c remain un-etched is not detrimental and creates no problem. In fact, this overcomes the problem of the edge effects which result from the un-etched portions of each individual circuit element in the conventional process, where the circuit pattern is first formed, and then is micro-roughened to create the improved adhesion to subsequently applied dielectric materials. In addition, this addresses and substantially avoids the problem of the reduction in size of each individual circuit element resulting from post-circuit element formation micro-roughening, which reduces the overall size of each circuit element below its initially-formed size.

As shown in Fig. 7b, the micro-roughening treatment forms a micro-roughened edge portion 712a of the inner layer 712.

As also shown in Fig. 7b, the edge of the underlying layer 714 is not etched or roughened by the micro-roughening treatment due to the galvanic edge effect described above. As with the edge portion 710c, the lack of micro-roughening at this point does not adversely impact the product, since this edge portion will be removed subsequently.

In the next step (c), of the process of the present invention, an etch resist is applied to the micro-roughened surface. After the micro-roughened panels are rinsed and dried, a suitable etch resist is applied to the surface, according to conventional processes. This resist may be in the form of a dry film, or it may be a liquid. In either case, the micro-roughened surface improves the adhesion of the etch resist such that it will not delaminate during the developing or etching steps. Any known type of etch resist and method of application may be used with this process. In one embodiment, the etch resist application operation comprises contacting the metal surface with a film of DuPont PM 120 etch resist and applying heat and pressure to the film by passing the assembly through a pair of pinch rollers which are heated to 110°C. In one embodiment, the linear speed of travel through the pinch rollers is 1 meter/minute.

In the next step (d), of the process, the etch resist is patterned to reveal areas of metal to be removed in forming the circuit pattern. Etch resist patterning may be performed by known processes, including exposing the resist material to ultraviolet light or laser energy. The exposure step may incorporate a mask to prevent exposure of certain areas to create a desired pattern, or the resist may be exposed by a direct write method. In either case, the etch resist is then brought into contact with a developing solution which dissolves the less chemically-resistant areas of the resist to reveal the underlying copper. Some etch resists are then cured by heat or UV energy to make them less susceptible to attack by the copper etching solution. Using the aforementioned DuPont PM120 etch resist, in one embodiment, a patterning operation includes exposing the etch resist material to 40 mJ/cm² of UV energy at a wavelength of about 330 to about 400 nm through a polyester phototool. After exposure, the protective polyester cover sheet is removed from the etch resist. The etch resist is then brought into contact with a developing solution containing 10 g/l potassium carbonate at 30°C which is sprayed at 1.379 bar (20 psi) for 50 seconds.

In the next step (e), of the process, the metal layer which is not protected is etched to form a circuit pattern. After rinsing, the exposed metal areas of the surface 710b are etched using oxidizing solutions known in the art. For copper, in one exemplary embodiment, an acidic solution based on cupric chloride and hydrochloric acid may be used. Such a solution contains a free hydrochloric acid concentration of 1.5N and a specific gravity of 1.28 g/ml. At a temperature of 55°C and a spray pressure of 20 psi, the copper etch rate is approximately 28 micron/minute. For CIC, in one exemplary embodiment, an etching solution comprises ferric chloride and hydrochloric acid. Such a solution contains a free hydrochloric acid concentration of 1.5N and a specific gravity of 1.33 g/ml. At a temperature of 50°C and a spray pressure of 1.379 bar (20 psi), the invar etch rate is approximately 15 micron/minute and the copper etch rate is approximately 30 micron/minute.

In the next step (f) of the process, the etch resist is removed. After etching and rinsing the copper or CIC, the etch resist is stripped with an appropriate stripping method. Any stripping method compatible with the etch resist that does not etch the metal can be used. For the aforementioned DuPont PM120, in one exemplary embodiment, the stripping operation includes contacting the etch resist with an aqueous solution containing 60 ml/l ResistStrip® RR-3 supplied by Atotech. The solution is sprayed onto the etch resist at a temperature of 55°C for at least 60 seconds at a pressure of 30 psi.

Steps (c) through (f) are conventional, and are not shown in the drawings for the sake of brevity.

Fig. 7c is a schematic cross-sectional view of a patterned micro-roughened mixed-metal layer 716, following the etching of the unpatterned mixed-metal layer 718 to form a circuit pattern 720 comprising a plurality of circuit pattern elements 702a-702d. As shown in Fig. 7c, the edge portions 710c of the patterned mixed-metal layer 716 (which were not micro-roughened due to the galvanic edge effect; see Fig. 7b) have been removed by the etching process in the embodiment shown in Fig. 7c. In other embodiments, the edge portions may be left in place, for example, to facilitate handling of the etched metal layers, and subsequently cut off during subsequent cutting or finishing operations. The removal or non-removal of these edge portions 710c can be selected by adjusting the location of the etch resist layer.

As shown in Fig. 7c, following etching to form the circuit pattern 720, each of the individual circuit elements 702a-702d are formed with an initial, selected width, and with an upper surface which has already been micro-roughened. There is no subsequent micro-roughening carried out, so each of the individual circuit elements 702a-702d thereafter retain their initial, selected width and none are left with upper surface areas which have not been micro-roughened. It is not necessary to design and etch the individual circuit elements 702a-702d to have a larger initial size in order to compensate for a size reduction which would occur if the micro-roughening was carried out after the etching to form the circuit pattern 720, and it is not necessary to find a remedy to the problem of un-roughened edge portions resulting from the galvanic edge effect. This feature of the present invention allows the circuit designer to design and build a mixed-metal circuit pattern, with improved adhesion to subsequently applied dielectric materials than would have been possible with prior art methods.

### COPPER AND OTHER NON-MIXED-METAL LAYERS

In another embodiment, a circuit board may include a single metal layer, such as a layer of copper or copper alloy.

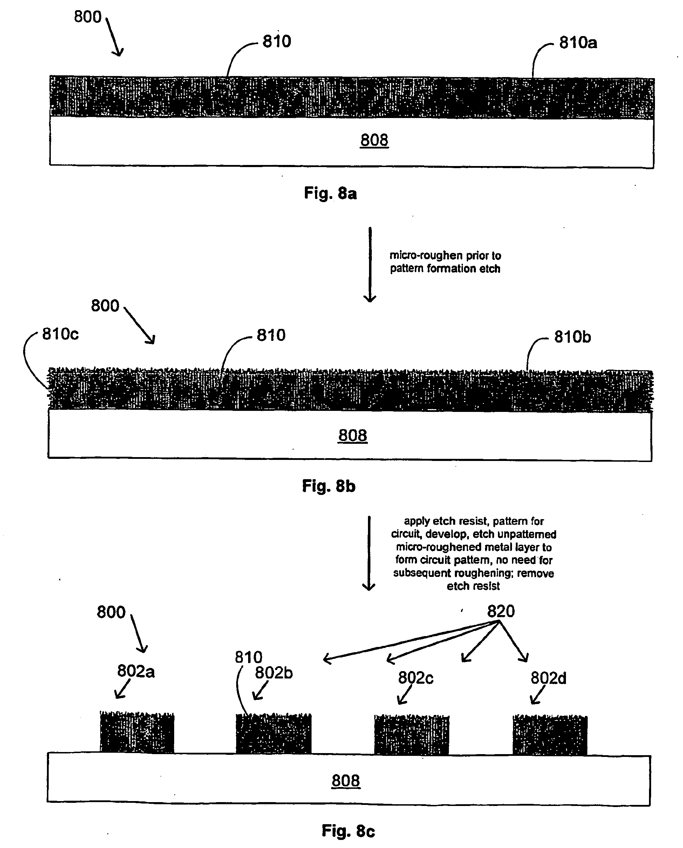

Fig. 8a is a schematic cross-sectional view of a nascent circuit 800, such as a printed circuit board, including an unpatterned metal layer 810 adhered or attached to a dielectric material layer 808. The metal layer 810 includes a first major surface 810a which in this embodiment is the only exposed major surface of the metal layer 810.

In one embodiment, the unpatterned metal layer 810 is provided in a continuous roll, and in another embodiment, the metal layer is provided in a square or rectangular sheet. In one embodiment, the unpatterned metal layer 810 is provided already adhered to a dielectric material layer 808. In another embodiment, the unpatterned metal layer 810 is provided and is subsequently applied to the dielectric material layer 808 prior to the micro-roughening and patterning. In yet another embodiment, the unpatterned metal layer 810 is provided, the micro-roughening carried out and the circuit pattern formed, and subsequently the formed circuit pattern is applied to the dielectric material layer 808.

The copper foils used with this invention are made using one of two techniques. Wrought or rolled copper foil is produced by mechanically reducing the thickness of a copper or copper alloy strip or ingot by a process such as rolling. Electrodeposited copper foil is produced by electrolytically depositing copper ions on a rotating cathode drum and then peeling the deposited foil from the cathode. Electrodeposited copper or copper-alloy foils are especially useful with this invention. Foils of metals other than copper may be produced by similar, known processes.

When the metal layers are metal foils, they typically have nominal thicknesses ranging from about 2.5 µm to about 500 µm or more. Foil thickness, and particularly copper foil thickness, may be expressed in terms of weight and typically the foils of the present invention have weights or thicknesses ranging from about 0.35 to about 43 g/dm² (about 1/8 to about 14 ounces per square foot (oz/ft²)). Especially useful copper foils are those having weights of ½, 1 or 2 oz/ft² (1.52, 3.05 or 6.10 g/dm²).

In the next step (b) of the second embodiment of the process of the present invention, shown in Fig. 8b, the first major surface 810a of the unpatterned metal layer 810 is treated with a micro-roughening solution, in a step of micro-roughening the surface 810a, to create a micro-roughened major surface 810b, and a micro-roughened side surface 81 0c, of the unpatterned metal layer 810 as shown in Fig. 8b. A number of solutions suitable for micro-roughening the surface 810a may be employed to create the micro-roughened surfaces 810b and 810c, and several are disclosed below. In one embodiment, the micro-roughening may also be referred to as intergranular etching.

As shown in Fig. 8b, following the micro-roughening, the unpatterned metal layer 810 has the micro-roughened surface 810b. In this embodiment, as shown in Fig. 8b, the metal layer 810 also includes an etched edge portions 810c. In contradistinction to the mixed-metal embodiment described above, the edge portion 810c is etched in this embodiment since there is no effect from an inner layer made of a different metal and causing a galvanic edge effect. As schematically shown in Fig. 8b, the entirety of the exposed surfaces of the metal layer 810 are relatively evenly micro-roughened as desired. As will be described in more detail below, micro-roughening at this point results in avoidance or significant or nearly complete reduction of the problem of the reduction in cross-sectional area of each individual circuit element and concomitant increase in resistivity, as described above with respect to Figs. 3a-3c.

In the next step (c) of this embodiment of the process of the present invention, an etch resist is applied to the micro-roughened surface. After the micro-roughened panels are rinsed and dried, a suitable etch resist is applied to the micro-roughened surface 810b, according to conventional processes. This resist may be in the form of a dry film, or it may be a liquid. In either case, the micro-roughened surface 810b improves the adhesion of the etch resist such that it will not delaminate during the developing or etching steps. Any known type of etch resist and method of application may be used with this process. In one embodiment, the etch resist application operation comprises contacting the metal surface with a film of DuPont PM 120 etch resist and applying heat and pressure to the film by passing the assembly through a pair of pinch rollers which are heated to 110°C. The linear speed of travel through the pinch rollers is 1 meter/minute.

In the next step (d) of the process, the etch resist is patterned to reveal areas of metal to be removed in forming the circuit pattern, as described above with respect to the CIC embodiment described with respect to Fig. 7a-7c. That disclosure is not repeated here for the sake of brevity, but is incorporated by reference with respect to this embodiment.

In the next step (e) of the process, the metal layer which is not protected is etched to form a circuit pattern. After rinsing, the exposed metal areas are etched using oxidizing solutions known in the art, as described above with respect to the CIC embodiment described with respect to Fig. 7a-7c. That disclosure is not repeated here for the sake of brevity, but is incorporated by reference with respect to this embodiment.

In the next step (f) of the process, the etch resist is removed. After etching and rinsing the copper, the etch resist is stripped with an appropriate stripping method, as described above with respect to the CIC embodiment described with respect to Fig. 7a-7c. That disclosure is not repeated here for the sake of brevity, but is incorporated by reference with respect to this embodiment.

Steps (c) through (f) are conventional, and are not shown in the drawings for the sake of brevity.

Fig. 8c is a schematic cross-sectional view of a micro-roughened mixed-metal layer 816, following the etching of the layer 816 to form a circuit pattern 820 comprising a plurality of circuit pattern elements 802a-802d, and subsequent removal of the etch resist. As shown in Fig. 8c, the edge portions 810c of the metal layer 810 (see Fig. 8b) have been removed by the etching process in the embodiment shown in Fig. 8c. In other embodiments, the edge portions may be left in place, for example, to facilitate handling of the etched metal layers, and subsequently cut off during finishing operations. The removal or non-removal of these edge portions 810c can be selected depending on the location of the etch resist layer.

As shown in Fig. 8c, following etching to form the circuit pattern 820, each of the individual circuit elements 802a-802d are formed with an initial, selected width, and with an upper surface which has already been micro-roughened. In one embodiment, there is no subsequent micro-roughening carried out, so each of the individual circuit elements 802a-802d thereafter retain their initial, selected width. Thus, it is not necessary to design and etch the individual circuit elements 802a-802d to have a larger size to compensate for a size reduction which would occur if the micro-roughening was carried out after the etching to form the circuit pattern 820. This feature of the present invention allows the circuit designer to design and build a smaller circuit pattern, with more narrowly spaced individual circuit pattern elements, than would be possible with prior art methods, in which the circuit pattern would have to be made larger initially.

At this point, in one embodiment, the process according to the present invention is complete. The etched metal layer having the circuit pattern may thereafter be treated according to known processes, for example, in applying chemical surface treatments or coatings for, e.g., enhancement of adhesion to dielectric materials, prevention of corrosion, etc., and in applying a dielectric material. Some suitable exemplary treatments are described in the following.

In the third embodiment of the present invention, additional steps are included, specifically, a dielectric material layer is applied, and optionally, a metal layer may be applied to further enhance adhesion to the dielectric material.

The steps (a)-(f) of the third embodiment may be substantially the same as those described above with respect to the second embodiment.

In the next step (h) of the third embodiment of the process of the present invention, a dielectric material layer is applied to the micro-roughened surface of the circuit pattern. After rinsing and drying, the patterned circuit is ready for dielectric application. The surface is already appropriately micro-roughened to have reliable adhesion to dielectric material. However, certain dielectric materials which exhibit poor adhesion to copper may show improved adhesion when a secondary metal is applied by chemical reaction to the surface of the micro-roughened copper. For example, a thin layer of tin may be applied to the copper surface using a replacement reaction, also known as an immersion tin process. Other metals which can enhance adhesion to dielectric materials include, but are not limited to, nickel, bismuth, lead, zinc, indium, palladium, ruthenium, chromium, and cobalt, as well as oxides and alloys of these materials where the specified metal is at least 50 percent by weight of the alloy. An example of such an alloy is nickel-phosphorous, where the phosphorous content of the alloy is 6% to 15% by weight. In one embodiment, the secondary metal layer is very thin, so that the surface structure of the underlying copper is not substantially modified.

In an optional step (g) of either the second or third embodiments of the process of the present invention, a secondary metal coating may be applied to the micro-roughened surface. In one embodiment, a secondary metal application operation includes contacting the patterned metal structures with a solution of Secure™ Enhancer supplied by Atotech. The solution contains 500 ml/l Secure™ Enhancer 300, 83 ml/l Secure™ Enhancer 400, and 100 ml/l sulfuric acid (sp. gr. 1.8). In one embodiment, at a temperature of 35°C, the immersion time is about 40 seconds. This will leave a tin layer on the copper or CIC that is approximately 0.15 microns thick, and the underlying copper structure is not substantially modified. That is, the micro-roughened surface is simply coated, and its overall shape is retained. In other embodiments, additional coatings known in the art may be applied to the secondary metal to further enhance the dielectric adhesion, such as organo-silane materials.

Prior to application of the dielectric layer, it is generally advantageous to inspect the patterned micro-roughened metal structures. This inspection usually includes an optical observation of the patterned structures, either manually by a human or automatically by a computerized machine. In order to aid the optical inspection operation, an additional step may be added prior to etch resist application or after etch resist stripping in order to chemically adjust the color of the micro-roughened surface. In either case, the color adjustment operation should not substantially modify the micro-roughened surface structure. Color adjustment can be performed by any chemical reaction. In one embodiment, the color adjustment operation includes contacting the micro-roughened metal with an aqueous solution containing 10 ml/l sulfuric acid (s. g.1.8) and 10 ml/l of 35 wt% hydrogen peroxide. The solution is sprayed onto the micro-roughened surface at 20 psi for 20 seconds at 35°C. Subjecting a copper surface that was micro-roughened with BondFilm® to such a color adjustment operation changes the surface color from dark brown to light orange-pink, and the surface structure is not substantially modified.

The dielectric may be applied by any means used in the industry. Certain dielectric materials are available in liquid form and are cast onto the surface and cured. Other dielectric materials are available in a B-stage cured sheet and require heat and pressure to bond reliably to the patterned metal structures. Still other dielectric materials are applied by plasma vapor deposition. The type of dielectric used and the method of application vary depending on the product. The invention can be used for all of these applications.

### MICRO-ROUGHENING PROCESSES

A number of suitable micro-roughening processes are known for use with the present invention. Several such processes are briefly described in the following disclosure. These are meant to be exemplary only, and the invention is not necessarily limited to any of them.

In one embodiment, the micro-roughening is carried by use of an aqueous composition containing an acid, an oxidizer and a corrosion inhibitor. In one embodiment, the oxidizer may be, for example, hydrogen peroxide at a concentration of about 6 to about 60 grams per liter (g/l), or from about 12 g/l to about 30 g/l. In one embodiment, the oxidant includes one or more of a peroxide, a peracid, a halide, a nitrate, cupric ion, ferric ion or other metal ion capable of oxidizing the metal surface. The acid may be any acid, such as a mineral acid like sulfuric acid, in one embodiment, at a concentration from about 5 g/l to about 360 g/l, or about 70 g/l to about 110 g/l of the composition. The corrosion inhibitor may be one or more of triazoles, benzotriazoles, tetrazoles, imidazoles, benzimidazoles and mixtures of the foregoing. In one embodiment, the corrosion inhibitor concentration may range from about 1 g/l to about 20 g/l, or from about 6 g/l to about 12 g/l . In one embodiment, the composition may also include a water soluble polymer such as polyethylene glycol, polypropylene glycol, polyvinyl alcohol, and mixtures of the foregoing.

In one embodiment, the micro-roughening composition is BondFilm® supplied by Atotech. The BondFilm® micro-roughening composition is provided as BondFilm® Part A and BondFilm® Part B. BondFilm® includes hydrogen peroxide, sulfuric acid and benzotrlazole, together with other proprietary ingredients.

Additional examples of such micro-roughening processes are described in U.S. Patent Nos. 6,036,758, 6,294,220, 5,807,493 and 6,506,314. For example, in U.S. Patent No. 6,506,314, micro-roughening is referred to as intergranular etching. This patent describes a number of suitable micro-roughening compositions, any one of which may be used in carrying out the present invention. The following micro-roughening compositions are disclosed in U.S. Patent No. 6,506,314, and are briefly reviewed herein.

In one embodiment, the micro-roughening is carried out by applying an aqueous composition comprising (a) hydrogen peroxide; (b) at least one acid; (c) at least one nitrogen-containing, five-membered heterocyclic compound which does not contain any sulphur, selenium or tellurium atom in the heterocycle; and (d) at least one adhesive compound from the group consisting of sulfinic acids, seleninic acids, tellurinic acids, heterocyclic compounds containing at least one sulphur, selenium and/or tellurium atom in the heterocycle, and sulfonium, selenonium and telluronium salts having the general formula (I), 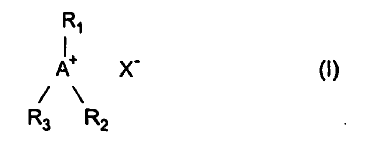 wherein in formula (I)
A is S, Se or Te;
R₁, R₂ and R₃ are independently C₁-C₆ alkyl, substituted alkyl, alkenyl, phenyl, substituted phenyl, benzyl, cycloalkyl, substituted cycloalkyl, R₁, R₂ and R₃ being the same or different; and
X⁻ is an anion of an inorganic or organic acid or hydroxide, provided that the acid selected to constitute component (b) is not identical to the sulfonic, seleninic or tellurinic acids selected as component (d).

In one embodiment of the micro-roughening composition, component (c) comprises one or more nitrogen containing heterocyclic compounds selected from triazoles, tetrazoles, imidazoles, pyrazoles and purines.

In one embodiment of the micro-roughening composition, component (c) is a triazole of the chemical formula (II): 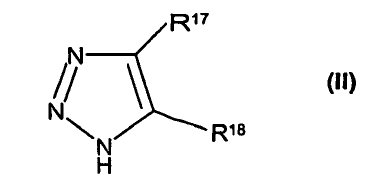 wherein in formula (II), R¹⁷ and R¹⁸ may be hydrogen, alkyl, substituted alkyl, phenyl, substituted phenyl, amino, carboxyalkyl, and whereby R¹⁷ and R¹⁸ may be the same or different, or in which R¹⁷ and R¹⁸ may be combined to form homo- or heterocyclic rings condensed with the triazole ring.

In one embodiment of the micro-roughening composition, component (c) is a tetrazole of the chemical formula (III): 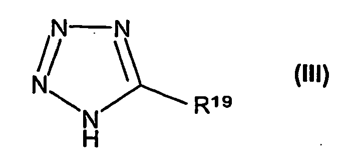 wherein in formula (III), R¹⁹ may be hydrogen, alkyl, substituted alkyl, phenyl, substituted phenyl, haloalkyl, amino, benzyl, carboxy, carboxyalkyl, alkoxycarbonyl, aminocarbonyl, R¹²-CONH- wherein R¹² may be as defined above.

In one embodiment, the tetrazole is 5-aminotetrazole. In another embodiment, the tetrazole is 5-phenyltetrazole.

In one embodiment of the micro-roughening composition, component (c) includes an imidazole compound. In another embodiment, the imidazole is benzimidazole.

Exemplary embodiments of component (c) are 5-phenyltetrazole, benzotriazole, methylbenzotriazole and ethylbenzotriazole. In one embodiment, the microroughening composition of this embodiment includes a combination of a nitrogen-containing heterocyclic compound, such as benzotriazole, methylbenzotriazole, ethylbenzotriazole, 5-aminotetrazole or 5-phenyltetrazole, as component (c), with heterocyclic compounds such as aminothiophene carboxylic acids, their esters or amides, aminothiazolenes and substituted aminothiazolenes, as component (d).

In one embodiment of the micro-roughening composition, component (d) is a sulfinic acid selected from aromatic sulfinic acids and compounds having the general formula (IV): 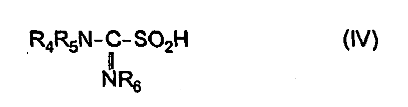 wherein in formula (IV),
R₄, R₅ and R₆ = H, alkyl, substituted alkyl, phenyl, substituted phenyl, R₇-(CO)-, wherein R₇ = H, alkyl, substituted alkyl, phenyl, substituted phenyl, and wherein R₄, R₅ and R₆ may be the same or different. In one embodiment, component (d) is formamidine sulfinic acid.

In one embodiment of the micro-roughening composition, component (d) comprises one or more heterocyclic compounds selected from thiophenes, thiazoles, isothiazoles, thiadiazoles and thiatriazoles. In another embodiment, component (d) comprises one or more sulfinic acid compounds selected from benzene sulfinic acid, toluene sulfinic acid, chlorobenzene sulfinic acid, nitrobenzene sulfinic acid and carboxybenzene sulfinic acid. In another embodiment, component (d) comprises one or more sulfonium salts selected from trimethyl sulfonium salts, triphenyl sulfonium salts, methioninealkyl sulfonium salts, and methionine benzylsulfonium salts.

In one embodiment of the micro-roughening composition, component (d) is a thiophene compound having the chemical formula (V): 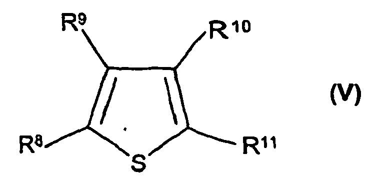 wherein in formula (V),
R⁸, R⁹, R¹⁰ and R¹¹ may be hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R¹²-CONH-, wherein R¹² may be hydrogen, alkyl, substituted alkyl, phenyl, substituted phenyl, whereby R⁸, R⁹, R¹⁰ and R¹¹ may be the same or different, or wherein two or more of R⁸, R⁹, R¹⁰ and R¹¹ may be combined to form homo- or heterocyclic rings condensed with the thiophene ring.

In one embodiment, the thiophene is an aminothiophenecarboxylic acid, ester or amide. In another embodiment, the thiophene is 3-aminothiophene-2-carboxylate methyl ester.

In one embodiment of the micro-roughening composition, component (d) is a thiazole of the chemical formula (VII): 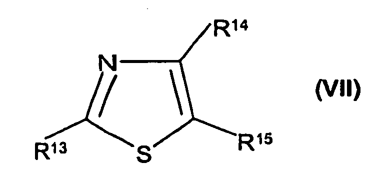 wherein in formula (VII),
R¹³, R¹⁴ and R¹⁵ may be hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R¹²-CONH-, wherein R¹² may be as defined above, whereby R¹³, R¹⁴ and R¹⁵ may be the same or different, or in which two or more of R¹³, R¹⁴ and R¹⁵ may be combined to form homo- or heterocyclic rings condensed with the thiazole ring.

In one embodiment, the thiazole is an aminothiazole or a substituted aminothiazole. In addition, the compounds of component (d) may be thiadiazoles substituted with the same R groups as above. In one embodiment, the thiadiazole is an aminothiadiazole or a substituted aminothiadiazole.

The components of this embodiment of the micro-roughening solution, when present, may be present in the following exemplary concentration ranges:

| | |
|---|---|
| Sulfuric acid, concentrated: | 10 to 250 g/l |
| Hydrogen peroxide, 30 wt% solution: | 1 to 100 g/l |
| 5-membered nitrogen-containing heterocyclic compound: | 0.5 to 50 g/l |
| Adhesive compounds containing sulfinic, selenic or telluric acids: | 0.05 to 10 g/l |
| Adhesive heterocyclic compounds: | 0.05 to 20 g/l |
| Sulfonium, Selenonium or Telluronium salts | 0.01 to 10 g/l |

The foregoing micro-roughening solution may be suitably applied as further described in U.S. Patent No. 6,506,314.

In one embodiment, the micro-roughening is carried out by applying an aqueous composition comprising from about 5 g/l to about 50 g/l hydrogen peroxide and about 0.1 g/l to about 50 g/l of an aromatic sulfonic acid or a salt thereof, such as sodium m-nitrobenzene sulfonate or other known aromatic sulfonic acids such as benzene sulfonic acids, which may be unsubstituted or substituted by one or more substituents, such as nitro, hydroxy, halogen, lower (C₁-C₆) alkyl, lower (C₁-C₆) alkoxy and other substituents. The sulfonic acid may be present as a salt, such as alkali metal salts. In alternative embodiments, the oxidizing agent may be ferric nitrate, ferric sulfate, sodium persulfate, etc., although hydrogen peroxide is more often used. In one embodiment, the composition may further include an inorganic acid, such as sulfuric acid. In one embodiment of the above-described peroxide/sulfonic micro-roughening composition, the composition includes a corrosion inhibitor, such as benzotriazole, other triazoles, tetrazoles and imidazoles.

In one embodiment, the micro-roughening is carried out by applying an aqueous composition comprising (a) a cupric ion source, (b) an organic acid with an acid dissociation constant (pKa) of 5 or lower, (c) a halide ion source, and (d) water. This micro-roughening process may use as the cupric ion source one or more compound(s) selected from a cupric salt of an organic acid, cupric chloride, cupric bromide and cupric hydroxide. The organic acid having a pKa of 5 or lower may be one or a mixture of organic acids, such as formic acid, acetic acid, propionic acid, butyric acid, valeric acid, caproic acid, acrylic acid, crotonic acid, iso-crotonic acid, oxalic acid, malonic acid, succinic acid, glutaric acid, adipic acid, pimelic acid, maleic acid, benzoic acid, phthalic acid, cinnamic acid, glycolic acid, lactic acid, malic acid, citric acid, sulfamic acid, β-chloropropionic acid, nicotinic acid, ascorbic acid, hydroxyl pivalic acid and levulinic acid. The halide ion may be provided in the form of a halide acid or a salt thereof.

In one embodiment, the micro-roughening is carried out with an aqueous composition comprising 0.1 to 20% by weight hydrogen peroxide; an inorganic acid; an organic corrosion inhibitor; and a surfactant. The hydrogen peroxide may be present at a concentration, in one embodiment, from about 0.01 % by weight up to about 20% by weight of the composition, and in one embodiment, from about 3% to about 10% by weight. The inorganic acid may be, for example sulfuric acid or phosphoric acid, and may be present at a concentration, in one embodiment, from about 1% by weight to about 50% by weight, and in another embodiment, about 10% by weight to about 30% by weight. The corrosion inhibitor may be one or more selected from triazoles, tetrazoles and imidazoles, and mixtures thereof, for example benzotriazole, which may be substituted with, for example, C₁-C₄ alkyl substituents. The corrosion inhibitor may be present in the composition, in one embodiment, from 0.0001 % by weight to about 1 % by weight of the composition, and in one embodiment, from about 0.1 % to about 0.5%. The surfactant may be a cationic surfactant, such as an amine surfactant, or a quaternary ammonium surfactant. The surfactant may be present at a concentration, in one embodiment, from about 0.001 % by weight to about 5% by weight of the composition, and in one embodiment, about 0.01 % to about 1 % by weight.

In one embodiment, the micro-roughening is carried out with an aqueous composition comprising (a) an acid; (b) a copper complexing agent; (c) a metal capable of having a multiplicity of oxidation states which is present in one of its higher positive oxidation states and which metal forms a composition soluble salt, and (d) oxygen. The acid may be a mineral acid, such as sulfuric or fluoboric, or an organic acid, such as acetic acid, an alkane sulfonic acid, an al kanol sulfonic acid, or mixtures of any thereof. The acid may be present at a concentration, in one embodiment, from about 20 to about 400 grams of acid, and in one embodiment, from about 50 to about 150 grams of acid, per liter of the micro-roughening composition. The pH of the composition may range from zero to about 6, and in one embodiment, from zero to about 3. The complexing agent may be at least one selected from urea and thiourea compounds, amidines, and imidazole thiones, such as, for example, thiourea or 1-methyl-3-propyl imidazole-2-thione. The complexing agent may be present at a concentration, in one embodiment, ranging from about 5 to about 200 g/l of composition, and in one embodiment, from about 25 to about 75 g/l of composition. The metal is one or more metals capable of having a multiplicity of oxidation states, which metal is present in one of its higher positive oxidation states, and which metal forms a composition soluble salt. Examples of such metals include tin, lead, platinum, and palladium which have positive oxidation states of +2 and +4; bismuth and antimony which have positive oxidation states of +3 and +5; and cerium and titanium which have positive oxidation states of +3 and +4. The composition should contain more than 4 grams per liter of the metal in the higher oxidation state. The amount of oxygen present in the composition ranges from about 1 to about 15 mg per liter of composition, and in one embodiment, from about 5 to about 9 mg per liter of composition. The metal ion acts as an oxidizing agent for copper in the micro-roughening, and is reduced from the higher positive oxidation state to the lower positive oxidation state. The metal is then re-oxidized to its higher oxidation state by the oxygen in the composition. The composition also may include one or more surfactants compatible with each of the metal salts, the acids and the complexing agent. The surfactant may be in a concentration, in one embodiment, from about 0.01 to about 100 grams per liter of bath, or from about 0.05 to about 20 grams per liter of the composition.

The processing conditions of the various embodiments of the micro-roughening may be suitably selected to yield the optimum micro-roughened surface of the metal layer, based on the particular metal substrate, i.e., copper, a copper alloy, etc. In general, the micro-roughening maybe carried out at a process temperature in the range from about 10°C to about 75°C, for a period of from about 1 minute to about 100 minutes, at atmospheric pressure.

In general, the greater the surface roughness, the greater will be the adhesion to dielectric material. However, as in the case of pre-treated CIC foil, too much roughness creates problems with etch resist patterning and stripping. In one embodiment, the process for creating micro-roughness includes use of BondFilm®, supplied by Atotech. This solution consists of 250 ml/l BondFilm® Part A and 35 ml/l BondFilm® Part B. The metal is immersed in this solution for 60 seconds at 35°C. Typically, the amount of copper removed by this process is from about 1.0 to about 1.5 microns, and the surface roughness (rₐ), as measured by a profilometer, is for example, from about 0.2 to about 0.4 microns. By comparison, pre-treated CIC foil has surface roughness (rₐ), as measured by a profilometer, in the range from about 1 to about 3 microns. The resist lock-in issues common to pre-treated foils are not likely to occur with micro-roughening processes using BondFilm® due to the lower surface roughness as compared to the pre-treated, e.g., dendritic surface.

While the invention has been explained in relation to certain specific embodiments, it is to be understood that various modifications thereof will become apparent to those skilled in the art upon reading the specification. Therefore, it is to be understood that the invention disclosed herein is intended to cover such modifications as fall within the scope of the appended claims.

## Claims

1. A process to improve adhesion of dielectric materials to a metal layer, comprising:
(a) providing an unpatterned metal layer (718, 810) having a first major surface (710a, 810a);
(b) micro-roughening the first major surface (710a, 810a) to form a micro-roughened surface (710b, 810b); and
(e) etching the metal layer to form a circuit pattern (720, 820) in the metal layer,
wherein the micro-roughening is carried out prior to the etching and the micro-roughened surface (710b, 810b) has a surface roughness rₐ as measured by profilometer of peak-to-valley height of features on the micro-roughened surface (710b, 810b) from 0.3 to 0.6 microns, and in the micro-roughening, surface area of the micro-roughened surface (710b, 810b) is increased by a factor of greater than 40% relative to the surface prior to the micro-roughening.

2. The process of claim 1, further comprising, prior to (e):
(c) applying an etch resist to the micro-roughened surface (710b, 810b); and
(d) patterning the etch resist to reveal areas of metal to be removed,
wherein (e) etches the metal layer which is not protected by the etch resist to form a circuit pattern; and, after (e)
(f) removing the etch resist.

3. The process of claim 2, further comprising, following step (f):
(g) optionally applying a secondary metal coating to the micro-roughened surface (710b, 810b); and
(h) applying a dielectric to the micro-roughened surface (710b, 810b).

4. The process of any preceding claim, wherein the micro-roughening is the first roughening treatment applied to the unpatterned metal layer (718, 810).

5. The process of any preceding claim, wherein the micro-roughening is the final roughening treatment applied to the metal layer.

6. The process of any preceding claim, further comprising cleaning the first major surface (710a, 810a) prior to the micro-roughening.

7. The process of claim 6, further comprising pre-conditioning the first major surface (710a, 810a) comprising applying a solution comprising a water soluble alcohol subsequent to the cleaning and prior to the micro-roughening.

8. The process of claim 7, wherein the solution further comprises a corrosion inhibitor.

9. The process of claim 2, further comprising removing the etch resist subsequent to the etching.

10. The process of either of claims 1 or 2, further comprising applying a secondary metal coating to the circuit pattern (720, 820).

11. The process of either of claims 1 or 2, further comprising applying a dielectric material to the circuit pattern (720, 820).

12. The process of any preceding claim, wherein the metal layer comprises a layer of copper.

13. The process of claim 12, wherein the metal layer comprises a layer of copper and a layer of a second metal or alloy.

14. The process of claim 13, wherein the second metal is an alloy of iron and nickel.

15. The process of claim 14, wherein the alloy comprises about 64 atomic percent iron and about 36 atomic percent nickel.

16. The process of any preceding claims, wherein the micro-roughening is carried out by applying a mixture comprising water, acid, an oxidant and a corrosion inhibitor to the unpatterned metal layer (718, 810).

17. The process of claim 16, wherein the acid comprises one or more of sulfuric acid, hydrochloric acid, a sulfonic acid, or an organic acid.

18. The process of claim 16, wherein the oxidant comprises one or more of a peroxide, a peracid, a halide, a nitrate, cupric ion or ferric ion.

19. The process of any preceding claim, wherein the micro-roughening is carried out by applying an aqueous composition comprising (a) hydrogen peroxide; (b) at least one acid; (c) at least one nitrogen-containing, five-membered heterocyclic compound which does not contain any sulphur, selenium or tellurium atom in the heterocycle; and (d) at least one adhesive compound from the group consisting of sulfinic acids, seleninic acids, tellurinic acids, heterocyclic compounds containing at least one sulphur, selenium and/or tellurium atom in the heterocycle, and sulfonium, selenonium and telluronium salts having the general formula (I), 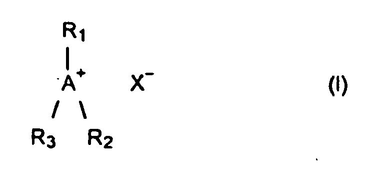 wherein in formula (I) A is S, Se or Te; R₁, R₂ and R₃ are independently C₁-C₆ alkyl, substituted alkyl, alkenyl, phenyl, substituted phenyl, benzyl, cycloalkyl, substituted cycloalkyl, R₁, R₂ and R₃ being the same or different; and
X¹ is an anion of an inorganic or organic acid or hydroxide, provided that the acid selected to constitute component (b) is not identical to the sulfinic, seleninic or tellurinic acids selected as component (d).

20. The process of any of claims 1-18, wherein the micro-roughening is carried out by applying an aqueous composition comprising from about 5 g/l to about 50 g/l hydrogen peroxide and about 0.1 g/l to about 50 g/l of an aromatic sulfonic acid or a salt thereof.

21. The process of any of claims 1-18, wherein the micro-roughening is carried out by applying an aqueous composition comprising (a) a cupric ion source, (b) an organic acid with an acid dissociation constant (pKa) of 5 or lower, (c) a halide ion source, and (d) water.

22. The process of any of claims 1-18, wherein the micro-roughening is carried out with an aqueous composition comprising 0.1 to 20% by weight hydrogen peroxide; an inorganic acid; an organic corrosion inhibitor; and a surfactant.

23. The process of any of claims 1-18, wherein the micro-roughening is carried out with an aqueous composition comprising (a) an acid; (b) a copper complexing agent; (c) a metal capable of having a multiplicity of oxidation states which is present in one of its higher positive oxidation states and which metal forms a composition soluble salt, and (d) oxygen.

24. The process of any preceding claim, wherein from about 0.5 to about 2 microns of metal is removed in the micro-roughening step.

25. The process of any preceding claim, wherein the micro-roughened surface (710b, 810b) covers about 90% or more of the first major surface (710a, 810a).

26. The process of any preceding claim, wherein the micro-roughened surface (710b, 810b) covers substantially all of the first major surface (710a, 810a).

27. The process of any preceding claim, wherein the metal layer is Copper-Invar-Copper (CIC).

## Patentansprüche

1. Verfahren zum Verbessern der Adhäsion von dielektrischen Materialien an eine Metallschicht, umfassend:
(a) Bereitstellen einer ungemusterten Metallschicht (718, 810) mit einer ersten Hauptoberfläche (710a, 810a);
(b) Mikroaufrauen der ersten Hauptoberfläche (710a, 810a) unter Bildung einer mikroaufgerauten Oberfläche (710b, 810b); und
(e) Ätzen der Metallschicht unter Bildung eines Leiterbildes (720, 820) in der Metallschicht,
wobei das Mikroaufrauen vor dem Ätzen durchgeführt wird und die mikroaufgeraute Oberfläche (710b, 810b) eine Oberflächenrauheit rₐ, wie mittels Profilometer gemessen als Spitze-zu-Tal-Höhe von Merkmalen auf der mikroaufgerauten Oberfläche (710b, 810b), von 0,3 bis 0,6 µm hat und bei dem Mikroaufrauen die Oberfläche der mikroaufgerauten Oberfläche (710b, 810b) um einen Faktor von größer als 40% in Relation zu der Oberfläche vor dem Mikroaufrauen erhöht wird.

2. Verfahren nach Anspruch 1, weiterhin umfassend, vor (e):
(c) Anbringen eines Ätz-Resists auf der mikroaufgerauten Oberfläche (710b, 810b); und
(d) Musterbildung an dem Ätz-Resist, um Metallflächen freizulegen, die entfernt werden sollen,
wobei (e) die nicht durch den Ätz-Resist geschützte Metallschicht ätzt, um ein Leiterbild zu bilden; und nach (e)
(f) Entfernen des Ätz-Resists.

3. Verfahren nach Anspruch 2, weiterhin umfassend, nach Stufe (f):
(g) gegebenenfalls Aufbringen einer zweiten Metallbeschichtung auf der mikroaufgerauten Oberfläche (710b, 810b); und
(h) Aufbringen eines Dielektrikums auf der mikroaufgerauten Oberfläche (710b, 810b).

4. Verfahren nach einem vorhergehenden Anspruch, wobei das Mikroaufrauen die erste Aufrauungsbehandlung ist, die auf die ungemusterte Metallschicht (718, 810) angewendet wird.

5. Verfahren nach einem vorhergehenden Anspruch, wobei das Mikroaufrauen die letzte Aufrauungsbehandlung ist, die auf die Metallschicht angewendet wird.

6. Verfahren nach einem vorhergehenden Anspruch, weiterhin umfassend das Reinigen der ersten Hauptoberfläche (710a, 810a) vor dem Mikroaufrauen.

7. Verfahren nach Anspruch 6, weiterhin umfassend Vorkonditionieren der ersten Hauptoberfläche (710a, 810a), umfassend das Anwenden einer Lösung, umfassend einen wasserlöslichen Alkohol, nach dem Reinigen und vor dem Mikroaufrauen.

8. Verfahren nach Anspruch 7, wobei die Lösung weiterhin einen Korrosionsinhibitor umfasst.

9. Verfahren nach Anspruch 2, weiterhin umfassend das Entfernen des Ätz-Resists nach dem Ätzen.

10. Verfahren nach einem der Ansprüche 1 oder 2, weiterhin umfassend das Aufbringen einer zweiten Metallbeschichtung auf das Leiterbild (720, 820).

11. Verfahren nach einem der Ansprüche 1 oder 2, weiterhin umfassend das Aufbringen eines dielektrischen Materials auf das Leiterbild (720, 820).

12. Verfahren nach einem vorhergehenden Anspruch, wobei die Metallschicht eine Kupferschicht umfasst.

13. Verfahren nach Anspruch 12, wobei die Metallschicht eine Kupferschicht und eine Schicht eines zweiten Metalls oder einer Legierung umfasst.

14. Verfahren nach Anspruch 13, wobei das zweite Metall eine Legierung aus Eisen und Nickel ist.

15. Verfahren nach Anspruch 14, wobei die Legierung etwa 64 Atomprozent Eisen und etwa 36 Atomprozent Nickel umfasst.

16. Verfahren nach einem vorhergehenden Anspruch, wobei das Mikroaufrauen durch Anwenden eines Gemisches, umfassend Wasser, Säure, ein Oxidationsmittel und einen Korrosionsinhibitor, auf die ungemusterte Metallschicht (718, 810) durchgeführt wird.

17. Verfahren nach Anspruch 16, wobei die Säure eine oder mehrere aus Schwefelsäure, Salzsäure, einer Sulfonsäure oder einer organischen Säure umfasst.

18. Verfahren nach Anspruch 16, wobei das Oxidationsmittel eines oder mehrere aus einem Peroxid, einer Persäure, einem Halogenid, einem Nitrat, Kupfer(II)-ionen oder Eisen(III)-ionen umfasst.

19. Verfahren nach einem vorhergehenden Anspruch, wobei das Mikroaufrauen durchgeführt wird, indem eine wässrige Zusammensetzung angewendet wird, umfassend (a) Wasserstoffperoxid; (b) mindestens eine Säure; (c) mindestens eine stickstoffhaltige, fünfgliedrige heterocyclische Verbindung, die kein Schwefel-, Selen- oder Telluratom in dem Heterocyclus enthält, und (d) mindestens eine adhäsive Verbindung aus der Gruppe, bestehend aus Sulfinsäuren, Seleninsäuren, Tellurinsäuren, heterocyclischen Verbindungen, die mindestens ein Schwefel-, Selen- und/oder Telluratom in dem Heterocyclus enthalten, und Sulfonium-, Selenonium- und Telluroniumsalze mit der allgemeinen Formel (I) 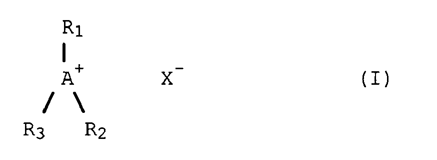 worin in Formel (I) A S, Se oder Te ist, R₁, R₂ und R₃ unabhängig C₁-C₆-Alkyl, substituiertes Alkyl, Alkenyl, Phenyl, substituiertes Phenyl, Benzyl, Cycloalkyl, substituiertes Cycloalkyl sind, wobei R₁, R₂ und R₃ gleich oder verschieden sind; und X⁻ ein Anion einer anorganischen oder organischen Säure oder ein Hydroxid ist, mit der Maßgabe, dass die Säure, die ausgewählt wurde, um die Komponente (b) darzustellen, nicht identisch ist mit den Sulfin-, Selenin- oder Tellurinsäuren, die als Komponente (d) ausgewählt wurden.

20. Verfahren nach einem der Ansprüche 1 bis 18, wobei das Mikroaufrauen durchgeführt wird, indem eine wässrige Zusammensetzung angewendet wird, umfassend von etwa 5 g/l bis etwa 50 g/l Wasserstoffperoxid und etwa 0,1 g/l bis etwa 50 g/l einer aromatischen Sulfonsäure oder eines Salzes davon.

21. Verfahren nach einem der Ansprüche 1 bis 18, wobei das Mikroaufrauen durchgeführt wird, indem eine wässrige Zusammensetzung angewendet wird, umfassend (a) eine Kupfer(II)-ionenquelle, (b) eine organische Säure mit einer Säuredissoziationskonstante (pKa) von 5 oder kleiner, (c) eine Halogenidionenquelle und (d) Wasser.

22. Verfahren nach einem der Ansprüche 1 bis 18, wobei das Mikroaufrauen mit einer wässrigen Zusammensetzung durchgeführt wird, umfassend 0,1 bis 20 Gew.-% Wasserstoffperoxid, eine anorganische Säure, einen organischen Korrosionsinhibitor und ein oberflächenaktives Mittel.

23. Verfahren nach einem der Ansprüche 1 bis 18, wobei das Mikroaufrauen mit einer wässrigen Zusammensetzung durchgeführt wird, umfassend (a) eine Säure, (b) ein Kupferkomplexierungsmittel, (c) ein Metall mit der Fähigkeit zum Aufweisen einer Mehrzahl von Oxidationszuständen, das in einem seiner höheren positiven Oxidationszustände vorliegt, und wobei das Metall ein in der Zusammensetzung lösliches Salz bildet, und (d) Sauerstoff.

24. Verfahren nach einem vorhergehenden Anspruch, wobei von etwa 0,5 bis etwa 2 µm Metall in der Stufe des Mikroaufrauens entfernt werden.

25. Verfahren nach einem vorhergehenden Anspruch, wobei die mikroaufgeraute Oberfläche (710b, 810b) etwa 90% oder mehr der ersten Hauptoberfläche (710a, 810a) abdeckt.

26. Verfahren nach einem vorhergehenden Anspruch, wobei die mikroaufgeraute Oberfläche (710b, 810b) im Wesentlichen die gesamte erste Hauptoberfläche (710a, 810a) abdeckt.

27. Verfahren nach einem vorhergehenden Anspruch, wobei die Metallschicht Kupfer-Invar-Kupfer (CIC) ist.

## Revendications

1. Un procédé pour améliorer l'adhésion de matériaux diélectriques à une couche métallique, comprenant les étapes:
(a) disposition d'une couche métallique non-dessinée (718,810) ayant une première surface principale (710a, 810a);
(b) micro-rugosification de la première surface principale (710a, 810a) pour former une surface micro-rugosifiée (710b, 810b) et
(e) gravure de la couche métallique pour produire un dessin de circuit (720, 820) dans la couche métallique,
dans lequel la micro-rugosification est effectuée avant la gravure et la surface micro-rugosifiée (710b, 810b) possède une rugosité de surface rₐ de 0,3 à 0,6 microns, mesurée par profilomètre et exprimée comme hauteur pic/vallée des caractéristiques à la surface micro-rugosifiée (710b, 810b), la superficie de la surface micro-rugosifiée (710b, 810b) est élevée par un facteur supérieur à 40% comparée avec la surface avant la micro-rugosification.

2. Le procédé selon la revendication 1 comprenant en outre avant l'étape (e):
(c) application d'un résist (etch resist) à la surface micro-rugosifiée (710b, 810b) et
(d) production d'un dessin du résist (etch resist) pour montrer des régions de métal à éliminer,
dans lequel (e) grave la couche du métal qui ne pas protégé par lé résist pour produire un dessin de circuit; et, après (e)
(f) enlèvement du résist.

3. Le procédé selon la revendication 2 comprenant en outre après l'étape (f):
(g) le cas échéant application d'un deuxième revêtement métallique à la surface micro-rugosifiée (710b, 810b) et
(h) application d'un diélectrique à la surface micro-rugosifiée (710b, 810b).

4. Le procédé selon l'une quelconque des revendications précédentes, dans lequel la micro-rugosification est le premier traitement de rugosification appliqué à la couche métallique non-dessinée (718, 810).

5. Le procédé selon l'une quelconque des revendications précédentes, dans lequel la micro-rugosification est le traitement final de rugosification appliqué à la couche métallique.

6. Le procédé selon l'une quelconque des revendications précédentes comprenant en outre un nettoyage de la première surface principale (710a, 810a) avant la micro-rugosification.

7. Le procédé selon la revendication 6 comprenant en outre le préconditionnement de la première surface principale (710a, 810a) comprenant application d'une solution comprenant un alcool soluble dans l'eau après le nettoyage et avant la micro-rugosification.

8. Le procédé selon la revendication 7, dans lequel la solution comprend en outre un inhibiteur de corrosion.

9. Le procédé selon la revendication 2 comprenant en outre l'élimination du résist après la gravure.

10. Le procédé selon la revendication 2 ou 3 comprenant en outre l'application d'un deuxième revêtement métallique sur le dessin de circuit (720, 820).

11. Le procédé selon la revendication 1 ou 2 comprenant en outre l'application d'un matériau diélectrique sur le dessin de circuit (720, 820).

12. Le procédé selon l'une quelconque des revendications précédentes, dans lequel la couche métallique comprend une couche de cuivre.

13. Le procédé selon la revendication 12 dans lequel la couche métallique comprend une couche de cuivre et une couche d'un deuxième métal ou d'un alliage.

14. Le procédé selon la revendication 13, dans lequel le deuxième métal est un alliage de fer et de nickel.

15. Le procédé selon la revendication 14, dans lequel l'alliage contient un pourcentage atomique de fer d'environ 64% et un pourcentage atomique de nickel d'environ 36%.

16. Le procédé selon l'une quelconque des revendications précédentes, dans lequel la micro-rugosification est effectuée par application d'un mélange comprenant de l'eau, de l'acide, un oxydant et un inhibiteur de corrosion sur la couche métallique non-dessinée (718, 810).

17. Le procédé selon la revendication 16, dans lequel ledit acide comprend un ou plusieurs parmi l'acide sulfurique, l'acide sulfonique ou une acide organique.

18. Le procédé selon la revendication 16, dans lequel l'oxydant comprend l'un ou plusieurs parmi un peroxyde, un peracide, un halogénure, un nitrate, les ions de cuivre (II) et les ions de fer (III).

19. Le procédé selon l'une quelconque des revendications précédentes, dans lequel la micro-rugosification est effectuée par application d'une composition aqueuse comprenant (a) du peroxyde d'hydrogène; (b) au moins un acide; (c) un composé hétérocyclique de 5 atomes qui contient au moins un atome d'azote, mais qui ne contient pas un atome de soufre, de sélénium ou de tellure dans l'hétérocycle et (d) au moins un composé adhésif choisi parmi le groupe consistant en les acides sulfiniques, les acides séléniniques, les acides telluriniques, les composés hétérocycliques contenant au moins un atome de soufre, de sélénium ou de tellure dans l'hétérocycle et les sels de sulfonium, de sélénonium et de telluronium ayant la formule générale (I): 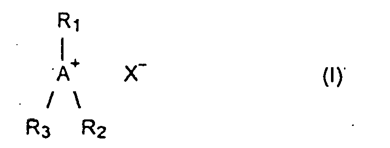 où A représente S, Se ou Te; R₁, R₂ et R₃ sont indépendamment un groupe alkyle en C₁-C₆, un groupe alkyle substitué, un groupe alcényle, un groupe phényle, un groupe phényle substitué, un groupe benzyle, un groupe cycloalkyle, un groupe cycloalkyle substitué, R₁, R₂ et R₃ étant identiques ou différents, et
X⁻ est an anion d'un acide anorganique ou d'un acide organique ou d'un hydroxyde anorganique ou organique sous réserve que l'acide, choisi pour constituer le composant (b), ne soit pas identique aux acides sulfiniques, séléniniques et telluriniques choisis comme composant (d).

20. Le procédé selon l'une quelconque des revendications 1 à 18, dans lequel la micro-rugosification est effectuée par application d'une composition aqueuse comprenant d'environ 5 g/l à environ 50 g/l de peroxyde d'hydrogène et d'environ 0,1 g/l à environ 50 g/l d'un acide sulfonique aromatique ou d'un sel de celui-ci.

21. Le procédé selon l'une quelconque des revendications 1 à 18, dans lequel la micro-rugosification est effectuée par application d'une composition aqueuse comprenant (a) une source d'ions de cuivre (II), (b) un acide organique ayant une constante de dissociation d'acidité (pka) de 5 ou inférieur, (c) une source d'ions halogène et (d) de l'eau.

22. Le procédé selon l'une quelconque des revendications 1 à 18, dans lequel la micro-rugosification est effectuée avec une composition aqueuse comprenant 0,1 à 20% en poids de peroxyde d'hydrogène; un acide inorganique; un inhibiteur de corrosion et un surfactant.

23. Le procédé selon l'une quelconque des revendications 1 à 18, dans lequel la micro-rugosification est effectuée avec une composition aqueuse comprenant (a) un acide; (b) un agent complexant pour le cuivre; un métal qui est capable d'avoir une multitude de degrés d'oxydation et qui est présente à un de ces plus hauts degrés d'oxydation positifs, et dans lequel ce métal forme un sel soluble dans la composition, et (d) d'oxygène.

24. Le procédé selon l'une quelconque des revendications précédentes, dans lequel d'environ 0,5 à environ 2 microns de métal sont éliminés dans l'étape de micro-rugosification.

25. Le procédé selon l'une quelconque des revendications précédentes, dans lequel la surface micro-rugosifiée (710b, 810b) couvre d'environ 90% ou plus de la première surface principale (710a, 810a).

26. Le procédé selon l'une quelconque des revendications précédentes, dans lequel la surface micro-rugosifiée (710b, 810b) couvre essentiellement la totalité de la première surface principale (710a, 810a).

27. Le procédé selon l'une quelconque des revendications précédentes, dans lequel la couche métallique est Copper-Invar-Copper (CIC).
